(19) Europäisches Patentamt
European Patent Office
Office européen des brevets

(11) EP 2 357 876 A1

(12) EUROPEAN PATENT APPLICATION
published in accordance with Art. 153(4) EPC

(43) Date of publication:
**17.08.2011 Bulletin 2011/33**

(21) Application number: **09811542.1**

(22) Date of filing: **03.09.2009**

(51) Int Cl.:
***H05K 3/34*** *(2006.01)* ***C09J 7/00*** *(2006.01)*
***C09J 9/02*** *(2006.01)* ***C09J 11/06*** *(2006.01)*
***C09J 163/02*** *(2006.01)* ***C09J 201/00*** *(2006.01)*
***H01R 11/01*** *(2006.01)*

(86) International application number:
**PCT/JP2009/065414**

(87) International publication number:
**WO 2010/027017 (11.03.2010 Gazette 2010/10)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **05.09.2008 JP 2008228907**
**26.06.2009 JP 2009152188**

(71) Applicant: **Sumitomo Bakelite Company Limited**
**Shinagawa-ku**
**Tokyo 140-0002 (JP)**

(72) Inventors:
- **OKADA Wataru**
  **Tokyo 140-0002 (JP)**
- **YAMAMOTO Michinori**
  **Tokyo 140-0002 (JP)**
- **CHUMA Toshiaki**
  **Tokyo 140-0002 (JP)**
- **MAEJIMA Kenzo**
  **Tokyo 140-0002 (JP)**
- **KAGIMOTO Tomohiro**
  **Tokyo 140-0002 (JP)**
- **KATSURAYAMA Satoru**
  **Tokyo 140-0002 (JP)**
- **FUJII, Tomoe**
  **Tokyo 140-0002 (JP)**

(74) Representative: **HOFFMANN EITLE**
**Patent- und Rechtsanwälte**
**Arabellastraße 4**
**81925 München (DE)**

# (54) ELECTROCONDUCTIVE CONNECTING MATERIAL, METHOD FOR CONNECTING TERMINALS TO EACH OTHER USING THE ELECTROCONDUCTIVE CONNECTING MATERIAL, AND METHOD FOR MANUFACTURING CONNECTING TERMINAL

(57) The present invention provides a conductive connecting material for electrically connecting terminals of electronic members, which has a layered structure comprising: a curable resin composition containing a resin component and a compound having a flux function; and a metal foil selected from a solder foil and a tin foil. Further, the present invention provides a method for connecting terminals comprising; a placement step in which the conductive connecting material is placed between opposed terminals; a heating step in which the conductive connecting material is heated at a temperature, which is equal to or higher than the melting point of the metal foil, and at which the resin composition is not completely cured or the resin composition is softened; and a curing step/solidifying step in which the resin composition is cured or solidified.

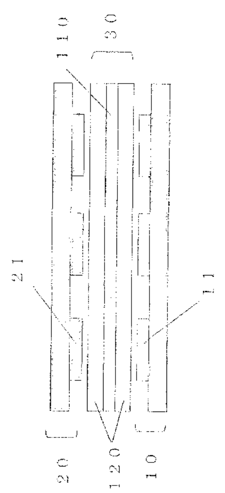


Fig. 1

EP 2 357 876 A1

**Description**

TECHNICAL FIELD

The present invention relates to a conductive connecting material comprising a resin composition containing a resin component and a compound having a flux function, and a metal foil (metal layer) selected from a solder foil and a tin foil; a method for electrically connecting opposed terminals of electronic members using the same; and a method for producing a connecting terminal using the same.

BACKGROUND ART

Recently, as the need for high-functional performance and miniaturization of electronic devices has been increased, the pitch between connecting terminals of electronic materials has been more and more narrowed, and connection between terminals in fine pitch circuits has also been sophisticated. As a method for connecting terminals, for example, a flip-chip connection technique, in which, when electrically connecting an Integrated Circuit (IC) chip to a circuit board, an anisotropic conductive adhesive or anisotropic conductive film is used to connect a plurality of terminals at the same time, is known. Such an anisotropic conductive adhesive or anisotropic conductive film is a film or paste in which conductive particles are dispersed in an adhesive containing a thermosetting resin as the main component. By placing this between electronic members to be connected and performing thermal compression bonding, a plurality of opposed terminals can be connected at the same time, and the insulation property between adjacent terminals can be ensured by the resin in the adhesive.

However, in an anisotropic conductive adhesive or anisotropic conductive film, it is difficult to control aggregation of conductive particles. Therefore, there are problems in which a part of opposed terminals are not conducted since a conductive particle and a terminal or conductive particles do not sufficiently contact to each other, and in which conductive particles remain in resin (insulating areas) positioned in areas other than those between opposed terminals (conductive areas) and therefore the insulation property between adjacent terminals cannot be sufficiently ensured. Therefore, it is difficult to further narrow the pitch between terminals.

When producing a connecting terminal for an electronic member, conventionally, a solder paste is used to produce the connecting terminal, which is printed onto a substrate having a metal pad and melted with heat using a reflow soldering oven or the like. However, in this method, when a pitch between connecting terminals to be produced is narrow, the cost of a mask for printing the solder paste is increased, and when the connecting terminal is small, printing may be impossible. In the case of a method in which a solder ball is mounted to a connecting terminal and the solder ball is melted with heat using a reflow soldering oven or the like, when the connecting terminal is small, the cost for producing the solder ball is increased, and it may be technically difficult to produce a small sized solder ball.

[Prior Art Document]

[Patent Documents]
[Patent Document 1] Japanese Laid-Open Patent Publication No. S61-276873
[Patent Document 2] Japanese Laid-Open Patent Publication No. 2004-260131

DISCLOSURE OF THE INVENTION

PROBLEMS TO BE SOLVED BY THE INVENTION

Under the above-described circumstances, it is desired to provide a conductive connecting material that ensures conductivity between opposed terminals and high insulation reliability between adjacent terminals. In addition, it is desired to develop a conductive connecting material that enables production of a connecting terminal on an electrode of an electric member using a convenient method.

MEANS FOR SOLVING THE PROBLEMS

The present invention relates to a conductive connecting material, a method for connecting terminals and a method for producing a connecting terminal as described below.

[1] A conductive connecting material, which has a layered structure comprising: a resin composition containing a

resin component and a compound having a flux function; and a metal foil selected from a solder foil and a tin foil.
[2] The conductive connecting material according to item [1], wherein in the layered structure, a metal foil layer is formed on at least a portion of a resin composition layer in a planar view.
[3] The conductive connecting material according to item [1], wherein in the layered structure, a metal foil layer is formed on at least a portion of a resin composition layer in a repeated pattern in a planar view.
[4] The conductive connecting material according to item [2] or [3], wherein in the layered structure, the metal foil layer is formed on at least a portion of the resin composition layer in a dotted line-like hole pattern, a stripe pattern, a polka-dot pattern, a rectangle pattern, a checker pattern, a frame pattern or a lattice pattern in a planar view.
[5] The conductive connecting material according to any one of items [1] to [4], comprising a layered structure consisting of a resin composition layer/a metal foil layer/a resin composition layer.
[6] The conductive connecting material according to any one of items [1] to [4], comprising a layered structure consisting of a resin composition layer/a metal foil layer.
[7] The conductive connecting material according to any one of items [1] to [5], wherein in the layered structure, the metal foil layer is formed approximately at the center in the thickness direction of the layered structure.
[8] The conductive connecting material according to any one of items [1] to [7], wherein the resin composition is in a liquid form at 25°C.
[9] The conductive connecting material according to any one of items [1] to [7], wherein the resin composition is in a film form at 25°C.
[10] The conductive connecting material according to any one of items [1] to [9], wherein the melt viscosity of the resin composition at the melting point of the metal foil is 0.01 to 10 Pa·s.
[11] The conductive connecting material according to any one of items [1] to [9], wherein the melt viscosity of the resin composition at the melting point of the metal foil is 10 to 100 Pa·s.
[12] The conductive connecting material according to any one of items [1] to [11], wherein the resin composition comprises a thermosetting resin.

[13] The conductive connecting material according to item [12], wherein the thermosetting resin comprises at least one selected from the group consisting of an epoxy resin, a (meth)acrylate resin, a phenoxy resin, a polyester resin, a polyimide resin, a silicone resin, a maleimide resin and a bismaleimide triazine resin.
[14] The conductive connecting material according to item [13], wherein the epoxy resin comprises a bisphenol A type epoxy resin or a bisphenol F type epoxy resin.
[15] The conductive connecting material according to any one of items [1] to [14], wherein the resin composition comprises a curing agent.
[16] The conductive connecting material according to any one of items [1] to [15], wherein the resin composition comprises a curing accelerator.
[17] The conductive connecting material according to item [16], wherein the curing accelerator is an imidazole compound.
[18] The conductive connecting material according to any one of items [1] to [17], wherein the compound having a flux function comprises a compound having a phenolic hydroxyl group and/or a carboxyl group.
[19] The conductive connecting material according to any one of items [1] to [18], wherein the compound having a flux function comprises a compound represented by the following general formula (1):

$$HOOC\text{-}(CH_2)n\text{-}COOH \cdots\cdots \quad (1)$$

wherein n is an integer from 1 to 20.
[20] The conductive connecting material according to any one of items [1] to [19], wherein the compound having a flux function comprises a compound represented by the following general formula (2) and/or (3):

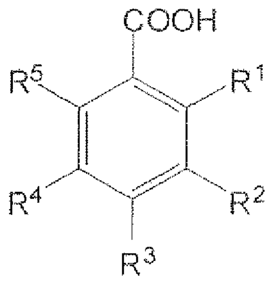

(2)

wherein $R^1$ to $R^5$ are each independently a monovalent organic group and at least one of $R^1$ to $R^5$ is a hydroxyl group;

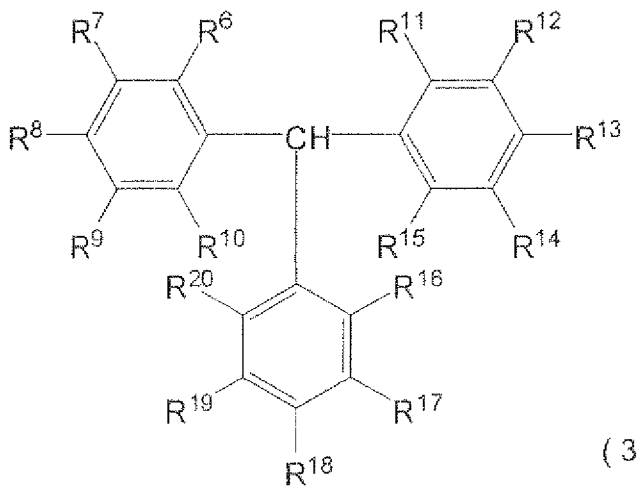

(3)

wherein $R^6$ to $R^{20}$ are each independently a monovalent organic group and at least one of $R^6$ to $R^{20}$ is a hydroxyl group or carboxyl group.

[21] The conductive connecting material according to any one of items [1] to [20], wherein the metal foil is formed by rolling, evaporation or plating.

[22] The conductive connecting material according to any one of items [1] to [21], wherein the melting point of the metal foil is 100 to 330°C.

[23] The conductive connecting material according to any one of items [1] to [22], wherein the metal foil is an alloy comprising at least two types of metals selected from the group consisting of Sn, Ag, Bi, In, Zn, Pb, Sb, Fe, Al, Ni, Au, Ge and Cu.

[24] The conductive connecting material according to any one of items [1] to [22], wherein the metal foil is made of Sn.

[25] A method for connecting terminals comprising: a placement step in which the conductive connecting material according to any one of items [1] to [24] is placed between opposed terminals; a heating step in which the conductive connecting material is heated at a temperature, which is equal to or higher than the melting point of the metal foil, and at which the resin composition is not completely cured; and a curing step in which the resin composition is cured.

[26] A method for connecting terminals comprising: a placement step in which the conductive connecting material according to any one of items [1] to [24] is placed between opposed terminals; a heating step in which the conductive connecting material is heated at a temperature, which is equal to or higher than the melting point of the metal foil, and at which the resin composition is softened; and a solidifying step in which the resin composition is solidified.

[27] The method according to item [25] or [26], wherein the melt viscosity of the resin composition in the heating step is 0.01 to 10 Pa·s.
[28] The method according to item [25] or [26], wherein the melt viscosity of the resin composition in the heating step is 10 to 100 Pa·s.

[29] A method for producing a connecting terminal comprising: a placement step in which the conductive connecting material according to any one of items [1] to [24] is placed on an electrode of an electronic member; and a heating step in which the conductive connecting material is heated at a temperature, which is equal to or higher than the melting point of the metal foil, and at which the resin composition is not completely cured.
[30] A method for producing a connecting terminal comprising: a placement step in which the conductive connecting material according to any one of items [1] to [24] is placed on an electrode of an electronic member; a heating step in which the conductive connecting material is heated at a temperature, which is equal to or higher than the melting point of the metal foil, and at which the resin composition is softened; and a solidifying step in which the resin composition is solidified.
[31] The method for producing a connecting terminal according to item [29] or [30], wherein the melt viscosity of the resin composition in the heating step is 0.01 to 10 Pa·s.
[32] The method for producing a connecting terminal according to item [29] or [30], wherein the melt viscosity of the resin composition in the heating step is 10 to 100 Pa·s.

[33] An electronic member with a conductive connecting material, wherein the conductive connecting material according to any one of items [1] to [24] is attached to an electrical connection surface of the electronic member.
[34] An electrical or electronic component, wherein electronic members are electrically connected to each other by the conductive connecting material according to any one of items [1] to [24].

In addition, the present invention relates to a conductive connecting material, a connecting material for terminals, etc. as described below.

[35] A conductive connecting material for electrically connecting terminals of electronic members, which has a layered structure comprising a curable resin composition containing a curable resin component and a flux and a solder foil.
[36] The conductive connecting material according to item [35], wherein the curable resin component comprises a bisphenol A type epoxy resin or a bisphenol F type epoxy resin.
[37] The conductive connecting material according to item [35] or [36], wherein the flux comprises a compound having a phenolic hydroxyl group or a compound having a carboxyl group.
[38] The conductive connecting material according to item [35] or [36], wherein the flux comprises sebacic acid or gentisic acid.
[39] The conductive connecting material according to any one of items [35] to [38], wherein the solder foil is an alloy comprising at least two types of metals selected from the group consisting of Sn, Ag, Bi, In, Zn and Cu.
[40] The conductive connecting material according to any one of items [35] to [39], wherein the melting point of the solder foil is 100 to 250°C.
[41] The conductive connecting material according to any one of items [35] to [40], wherein the curable resin composition comprises a curing accelerator.
[42] The conductive connecting material according to item [41], wherein the curing accelerator is an imidazole compound.
[43] A method for connecting terminals comprising: a placement step in which the conductive connecting material according to any one of items [35] to [42] is placed between opposed terminals; a heating step in which the conductive connecting material is heated at a temperature, which is equal to or higher than the melting point of the solder foil, and at which curing of the curable resin composition is not completed; and a curing step in which the curable resin composition is cured.
[44] The method for connecting terminals according to item [43], wherein the melt viscosity of the curable resin composition in the heating step is 0.01 to 10 Pa·s.

## ADVANTAGEOUS EFFECT OF THE INVENTION

According to a preferred embodiment of the present invention, by using the conductive connecting material of the present invention, solder or tin can be selectively aggregated between opposed terminals. As a result, it is possible to provide a terminal-to-terminal connection having high electrical conductivity and excellent connection reliability. In addition, it is possible to connect a plurality of terminals in a fine pitch circuit of a semiconductor device or the like at the same time. Moreover, by using the conductive connecting material of the present invention, solder or tin can be selectively aggregated at a portion to become a connecting terminal of an electronic member, and therefore, it is possible to produce a highly-reliable connecting terminal. Furthermore, by using a metal foil as a conductive material, it is possible to prevent from remaining of conductive particles in an insulating area, and as a result, it is possible to provide a highly reliable connection.

## BRIEF DESCRIPTION OF THE DRAWINGS

FIG. 1 is a schematic cross sectional view showing one example of the state of substrates and a conductive connecting material after the conductive connecting material is placed between terminals in the method for connecting terminals of the present invention.
FIG. 2 is a schematic cross sectional view showing one example of the state of substrates, conductive areas and insulating areas after the conductive connecting material placed between terminals is heated and cured/solidified in the method for connecting terminals of the present invention.
FIG. 3 is a schematic cross sectional view showing one example of the state of substrates and a conductive connecting material after the conductive connecting material is placed between terminals in the method for connecting terminals of the present invention.
FIG. 4 is a schematic cross sectional view showing one example of the state of a substrate and a conductive connecting material after the conductive connecting material is placed on electrodes provided on the substrate in the method for producing a connecting terminal of the present invention.
FIG. 5 is a schematic cross sectional view showing one example of the state of a substrate and a conductive connecting material after the conductive connecting material is placed on electrodes provided on the substrate in the method for producing a connecting terminal of the present invention.
FIG. 6 is a schematic cross sectional view showing one example of the state of a substrate, conductive areas and insulating areas after a conductive connecting material placed on electrodes on the substrate is heated and cured/solidified in the method for producing a connecting terminal of the present invention.
FIG. 7 is a plan view showing one example of the shape of a metal foil layer to be used in the present invention.

## BEST MODE FOR CARRYING OUT THE INVENTION

### 1. Conductive connecting material

The conductive connecting material of the present invention comprises: a resin composition containing a resin component and a compound having a flux function; and a metal foil selected from a solder foil and a tin foil, which has a layered structure comprising a resin composition layer and a metal foil layer. Each of the resin composition layer and the metal foil layer may consist of one layer or a plurality of layers. The layered structure of the conductive connecting material is not particularly limited and may be a two-layer structure of the resin composition layer and the metal foil layer (resin composition layer/metal foil layer), or a three-layer structure or multilayer structure having more than three layers, in which one or both of the resin composition layer and the metal foil layer consist of a plurality of layers. When using a plurality of resin composition layers or metal foil layers, compositions of respective layers may be the same or different.
In one embodiment of the present invention, in terms of reduction of an oxide layer on a metal foil surface using a compound having a flux function, upper and lower layers of the metal foil layer are preferably resin composition layers. For example, a three-layer structure (resin composition layer/metal foil layer/resin composition layer) is preferred. In this case, thicknesses of the resin composition layers on both sides of the metal foil layer may be the same or different. The thickness of the resin composition layer may be suitably adjusted depending on the height of a terminal to be connected, etc. For example, when producing a connecting terminal using a conductive connecting material in which thicknesses of resin composition layers on both sides of a metal foil layer are different, it is preferred that a thinner resin composition layer is placed on the connecting terminal side. By shortening the distance between the metal foil and the connecting terminal, it becomes easy to control aggregation of a solder or tin component to the connecting terminal portion.
In another embodiment of the present invention, for example, when producing a connecting terminal on an

electronic member such as a semiconductor wafer, a conductive connecting material preferably has a resin composition layer only on one side of a metal foil layer since a portion of the metal foil can be exposed. When connecting opposed connecting terminals using a conductive connecting material having a two-layer structure, the material may be placed so that the resin composition layer side is in contact with a connecting terminal or may be placed so that the metal foil layer side is in contact with a connecting terminal. The orientation of the conductive connecting material may be suitably selected depending on the pattern shape of the metal foil. When connecting opposed terminals of electronic members using a conductive connecting material having a two-layer structure, it is preferred that the conductive connecting material is attached to both of the opposed electronic members and subsequently the electronic members with the conductive connecting material are attached to each other.

Hereinafter, the resin composition layer and the metal foil layer constituting the conductive connecting material of the present invention will be described in more detail.

(1) Resin composition layer

In the present invention, the resin composition layer is constituted by a resin composition containing a resin component and a compound having a flux function. The resin composition to be used may be in a liquid form or solid form at room temperature. In the present invention, "a liquid form at room temperature" means a state of not having a certain form at room temperature (25°C), and a paste form is included therein.

The resin composition to be used in the present invention is not particularly limited as long as it contains a resin component and a compound having a flux function, and a curable resin composition or a thermoplastic resin composition can be used. Examples of the curable resin composition include a curable resin composition that is cured by heating, a curable resin composition that is cured by irradiation of chemical rays, etc. Among them, in terms of excellent mechanical properties such as a coefficient of thermal expansion and an elastic modulus after curing, the curable resin composition that is cured by heating is preferred.

The thermoplastic resin composition is not particularly limited as long as it has flexibility sufficient to be shaped by heating to a predetermined temperature.

(a) Curable resin composition

The curable resin composition that is preferably used in the present invention is not particularly limited as long as it contains a curable resin component and a compound having a flux function and is melted and cured by heating. Among them, a curable resin composition having a predetermined melt viscosity in the heating step is particularly preferred. For example, the melt viscosity of the curable resin composition at the melting point of the metal foil is preferably 100 Pa·s or less, more preferably 50 Pa·s or less, and even more preferably 10 Pa·s or less. Further, the melt viscosity is preferably 0.001 Pa·s or more, more preferably 0.005 Pa·s or more, and even more preferably 0.01 Pa·s or more. For example, the melt viscosity of the resin composition in the heating step is preferably 100 Pa·s or less, more preferably 50 Pa·s or less, and even more preferably 10 Pa·s or less. Further, the melt viscosity is preferably 0.001 Pa·s or more, more preferably 0.005 Pa·s or more, and even more preferably 0.01 Pa·s or more. In the present specification, "the melt viscosity of the curable resin composition at the melting point of the metal foil" or "the melt viscosity of the resin composition in the heating step", means a melt viscosity measured by obtaining a curing calorific value and a curing reaction rate using the method in the Examples.

In one embodiment of the present invention, the conductive connecting material of the present invention is placed between opposed terminals, and by heating the conductive connecting material, an oxide layer on a metal foil surface is removed by the function of a compound having a flux function to improve wettability on the metal. As a result, melted solder or tin moves in the curable resin component and aggregates between opposed terminals to form a conductive area. Meanwhile, the curable resin component surrounds the conductive area to form an insulating area. After terminals are electrically connected to each other via solder or tin, conductivity can be ensured by curing the curable resin component according to need. In addition, the insulation property between adjacent terminals can be ensured and the mechanical adhesion strength between opposed terminals can be increased.

In the case where a connecting terminal is produced on an electrode of an electronic member using the' conductive connecting material of the present invention, the conductive connecting material of the present invention is placed on a portion on which the connecting terminal is to be produced and heated, and as a result, solder or tin aggregates on the electrode, thereby producing the connecting terminal. When using the curable resin component, the connecting terminal may be connected to a desired electronic member or substrate before curing the curable resin component, followed by curing of the curable resin component. The mechanical strength of the connecting terminal may be improved by thinning the resin composition layer, coating the base portion of the formed connecting terminal with the resin composition and curing the curable resin component. In the case where a connecting terminal is produced on an electrode of an electronic member, the curable resin component may be cured when the connecting terminal is produced,

or may be cured after the connecting terminal is joined to a connecting terminal of another electronic member.

(i) Curable resin component

In general, the curable resin component to be used in the present invention is not particularly limited as long as it can be used as an adhesive component for production of semiconductor devices. Such a curable resin component is not particularly limited, but is preferably cured at a temperature that is equal to or higher than the melting point of the metal foil. Examples thereof include epoxy resin, phenoxy resin, silicone resin, oxetane resin, phenol resin, (meth) acrylate resin, polyester resin (unsaturated polyester resin), diallyl phthalate resin, maleimide resin, polyimide resin (polyimide precursor resin) and bismaleimide triazine resin. In particular, it is preferred to use a thermosetting resin comprising at least one selected from the group consisting of epoxy resin, (meth)acrylate resin, phenoxy resin, polyester resin, polyimide resin, silicone resin, maleimide resin and bismaleimide triazine resin. Among them, epoxy resin is preferred in terms of excellent curability and preservability and excellent heat resistance, moisture resistance and chemical resistance of a cured product. Further, such curable resin components may be used solely or in combination.

In the present invention, the form of the curable resin component can be suitably selected depending on the form of the curable resin composition, etc. When using a curable resin composition in a liquid form, it is preferred to use a curable resin component in a liquid form, and a film-forming resin component as described below may be used in combination according to need. When using a curable resin composition in a solid form, a curable resin component in a liquid or solid form may be used, and it is preferred to use a film-forming resin component in combination.

In the present invention, as the aforementioned epoxy resin, an epoxy resin in a liquid form at room temperature or an epoxy resin in a solid form at room temperature may be used. It is possible to use an epoxy resin in a liquid form at room temperature and an epoxy resin in a solid form at room temperature in combination. When the curable resin composition is in a liquid form, it is preferred to use an epoxy resin in a liquid form at room temperature. When the curable resin composition is in a solid form, it is possible to use an epoxy resin in a liquid or solid form, and it is preferred to suitably use a film-forming resin component in combination.

The epoxy resin in a liquid form at room temperature (25°C) to be used in the present invention is not particularly limited, and examples thereof include bisphenol A type epoxy resin and bisphenol F type epoxy resin. It is possible to use bisphenol A type epoxy resin and bisphenol F type epoxy resin in combination.

The epoxy equivalent of the epoxy resin in a liquid form at room temperature is preferably 150 to 300 g/eq, more preferably 160 to 250 g/eq, and particularly preferably 170 to 220 g/eq. When the epoxy equivalent is lower than the above-described lower limit, the shrinkage ratio of a cured product tends to be increased, and a warpage may be generated. When the epoxy equivalent is higher than the above-described upper limit, in the case where a film-forming resin component is used in combination, the reactivity with the film-forming resin component, in particular a polyimide resin tends to be reduced.

The epoxy resin in a solid form at room temperature (25°C) to be used in the present invention is not particularly limited, and examples thereof include bisphenol A type epoxy resin, bisphenol S type epoxy resin, phenol novolac type epoxy resin, cresol novolac type epoxy resin, glycidyl amine type epoxy resin, glycidyl ester type epoxy resin, trifunctional epoxy resin and tetrafunctional epoxy resin. Among them, solid trifunctional epoxy resin, cresol novolac type epoxy resin, etc. are preferred. Further, these epoxy resins may be used solely or in combination. The softening point of the epoxy resin in the solid form at room temperature is preferably 40 to 120°C, more preferably 50 to 110°C, and particularly preferably 60 to 100°C. When the softening point is within the above-described range, tackiness can be suppressed and the epoxy resin can be easily handled.

In the present invention, as such a curable resin component, a commercially-available product can be used. Moreover, within a range in which the effects of the present invention are not reduced, it is also possible to use a curable resin component in which various additives such as a plasticizing agent, a stabilizing agent, an inorganic filler, an antistatic agent and a pigment are blended.

In the conductive connecting material to be used in the present invention, the amount of the curable resin component can be suitably set depending on the form of a curable resin composition to be used.

For example, in the case of the curable resin composition in the liquid form, the amount of the curable resin component is preferably 10 parts by weight or more, more preferably 15 parts by weight or more, even more preferably 20 parts by weight or more, still more preferably 25 parts by weight or more, still even more preferably 30 parts by weight or more, and particularly preferably 35 parts by weight or more per 100 parts by weight of the conductive connecting material. Further, it is preferably 100 parts by weight or less, more preferably 95 parts by weight or less, even more preferably 90 parts by weight or less, still more preferably 75 parts by weight or less, still even more preferably 65 parts by weight or less, and particularly preferably 55 parts by weight or less. Further, the amount of the curable resin component is preferably 10 wt% or more, more preferably 15 wt% or more, even more preferably 20 wt% or more, still more preferably 25 wt% or more, still even more preferably 30 wt% or more, and particularly preferably 35 wt% or more with respect to the total weight of the curable resin composition. Further, it is preferably 100 wt% or less, more preferably 95 wt% or

less, even more preferably 90 wt% or less, still more preferably 75 wt% or less, still even more preferably 65 wt% or less, and particularly preferably 55 wt% or less.

In the case of the curable resin composition in the solid form, the amount of the curable resin component is preferably 5 parts by weight or more, more preferably 10 parts by weight or more, even more preferably 15 parts by weight or more, and particularly preferably 20 parts by weight or more per 100 parts by weight of the conductive connecting material. Further, it is preferably 90 parts by weight or less, more preferably 85 parts by weight or less, even more preferably 80 parts by weight or less, still more preferably 75 parts by weight or less, still even more preferably 65 parts by weight or less, and particularly preferably 55 parts by weight or less. Further, the amount of the curable resin component is preferably 5 wt% or more, more preferably 10 wt% or more, even more preferably 15 wt% or more, and particularly preferably 20 wt% or more with respect to the total weight of the curable resin composition. Further, it is preferably 90 wt% or less, more preferably 85 wt% or less, even more preferably 80 wt% or less, still more preferably 75 wt% or less, still even more preferably 65 wt% or less, and particularly preferably 55 wt% or less.

When the amount of the curable resin component is within the aforementioned range, the electrical connection strength and the mechanical adhesion strength between terminals can be ensured sufficiently.

(ii) Film-forming resin component

In the present invention, when using the curable resin composition in the solid form, it is preferred to use the curable resin component and a film-forming resin component in combination. The film-forming resin component is not particularly limited as long as it can be solved in an organic solvent and independently has film-forming ability. A thermoplastic resin or a thermosetting resin can be used, and they can be used in combination. Specific examples of the film-forming resin component include (meth)acrylic resin, phenoxy resin, polyester resin, polyurethane resin, polyamide resin, polyamide-imide resin, siloxane-modified polyimide resin, polybutadiene resin, polypropylene resin, styrene-butadiene-styrene copolymer, styrene-ethylene-butylene-styrene copolymer, polyacetal resin, polyvinyl butyral resin, polyvinyl acetal resin, butyl rubber, chloroprene rubber, polyamide resin, acrylonitrile-butadiene copolymer, acrylonitrile-butadiene-acrylic acid copolymer, acrylonitrile-butadiene-styrene copolymer, polyvinyl acetate and nylon. Among them, (meth)acrylic resin, phenoxy resin, polyester resin, polyamide resin and polyimide resin are preferred. Further, these film-forming resin components can be used solely or in combination.

In the present invention, the term "(meth)acrylic resin" refers to polymers of (meth)acrylic acid and derivatives thereof or a copolymer of (meth)acrylic acid or a derivative thereof and another monomer. In this regard, when describing "(meth)acrylic acid" or the like, it means "acrylic acid or methacrylic acid".

Examples of the (meth)acrylic resin include: polyacrylic acid; polymethacrylic acid; polyacrylic acid esters such as poly(methyl acrylate), poly(ethyl acrylate), poly(butyl acrylate), and 2-ethylhexyl-polyacrylate; polymethacrylic acid esters such as poly(methyl methacrylate), poly(ethyl methacrylate), and poly(butyl methacrylate); polyacrylonitrile; polymethacrylonitrile; polyacrylamide; butyl acrylate-ethyl acrylate-acrylonitrile copolymer; acrylonitrile-butadiene copolymer; acrylonitrile-butadiene-acrylic acid copolymer; acrylonitrile-butadiene-styrene copolymer; acrylonitrile-styrene copolymer; methyl methacrylate-styrene copolymer; methyl methacrylate-acrylonitrile copolymer; methyl methacrylate-$\alpha$-methylstyrene copolymer; butyl acrylate-ethyl acrylate-acrylonitrile-2-hydroxyethyl methacrylate-methacrylic acid copolymer; butyl acrylate-ethyl acrylate-acrylonitrile-2-hydroxyethyl methacrylate-acrylic acid copolymer; butyl acrylate-acrylonitrile-2-hydroxyethyl methacrylate copolymer; butyl acrylate-acrylonitrile-acrylic acid copolymer; butyl acrylate-ethyl acrylate-acrylonitrile copolymer; and ethyl acrylate-acrylonitrile-N,N-dimethylacrylamide copolymer. Among them, butyl acrylate-ethyl acrylate-acrylonitrile copolymer and ethyl acrylate-acrylonitrile-N,N-dimethylacrylamide are preferred. Further, these (meth)acrylic resins may be used solely or in combination.

Among these (meth)acrylic resins, a (meth)acrylic resin in which a monomer having a functional group (e.g., nitrile group, epoxy group, hydroxyl group and carboxyl group) is copolymerized is preferred in terms of the ability to improve adhesion to a material and compatibility with other resin components. In the case of such a (meth)acrylic resin, the amount of the monomer having the functional group is not particularly limited, but is preferably 0.1 to 50 mol%, more preferably 0.5 to 45 mol%, and particularly preferably 1 to 40 mol% with respect to 100 mol% of total monomers at the time of synthesis of the (meth)acrylic resin. When the amount of the monomer having the functional group is less than the lower limit, adhesion tends to be not sufficiently improved. When the amount exceeds the upper limit, adhesive force is too strong and workability tends to be not sufficiently improved.

The weight average molecular weight of the (meth)acrylic resin is not particularly limited, but is preferably 100,000 or more, more preferably 150,000 to 1,000,000, and particularly preferably 250,000 to 900,000. When the weight average molecular weight is within the above-described range, film-forming ability can be improved.

In the present invention, when using a phenoxy resin as the film-forming resin component, the number average molecular weight thereof is preferably 5,000 to 15,000, more preferably 6,000 to 14,000, and particularly preferably 8,000 to 12,000. When using the phenoxy resin, flowability of the conductive connecting material before cured can be suppressed.

In the present invention, examples of skeletons of the phenoxy resin include, but are not limited to, bisphenol A type, bisphenol F type and biphenyl skeleton type. Further, a phenoxy resin having a saturated water absorption rate of 1% or less is preferred because it can suppress generation of foam, peel-off or the like at a high temperature at the time of adhesive joining and solder mounting. With respect to the saturated water absorption rate: the phenoxy resin is processed to form a film having the thickness of 25 μm; the film is dried under the atmosphere of 100°C for 1 hour (absolute dry); subsequently, the film is left in a constant temperature and humidity bath under the atmosphere of 40°C, 90% RH; the mass change is measured every 24 hours; and using the mass at the time of saturation of the mass change, the saturated water absorption rate can be calculated according to the following formula: Saturated water absorption rate (%) = {(Mass at the time of saturation} - (Mass at the time of absolute dry)} / (Mass at the time of absolute dry) × 100

The polyimide resin to be used in the present invention is not particularly limited as long as it has imide bond in a repeat unit. Examples thereof include those obtained by reacting diamine with acid dianhydride and heating the obtained polyamide acid to cause dehydration and ring closure.

Examples of diamines include aromatic diamines (e.g., 3,3'-dimethyl-4,4'-diaminodiphenyl, 4,6-dimethyl-m-phenylenediamine, and 2,5-dimethyl-p-phenylenediamine), siloxanediamines (e.g., 1,3-bis(3-aminopropyl)-1,1,3,3-tetramethyldisiloxane), etc. These diamines can be used solely or in combination.

Further, examples of acid dianhydrides include 3,3,4,4'-biphenyl tetracarboxylic acid, pyromellitic dianhydride, and 4,4'-oxydiphthalic dianhydride. These acid dianhydrides can be used solely or in combination.

The polyimide resin to be used in the present invention may be soluble or insoluble in solvents. However, a polyimide resin that is soluble in solvents is preferred since varnish can be easily obtained at the time of mixing with other components and it is excellent in handleability. Siloxane-modified polyimide resin is particularly preferably used because it can be solved in various organic solvents.

The polyamide resin to be used in the present invention is not particularly limited, and examples thereof include: polyamide resin in which a cyclic aliphatic lactam is subjected to ring-opening polymerization such as 6-nylon and 12-nylon; polyamide resin in which aliphatic diamine and aliphatic dicarboxylic acid are subjected to condensation polymerization such as 6,6-nylon, 4,6-nylon, 6,10-nylon and 6,12-pylon, polyamide resin in which aromatic diamine and aliphatic dicarboxylic acid are subjected to condensation polymerization; polyamide resin in which aromatic diamine and aromatic dicarboxylic acid are subjected to condensation polymerization; and polyamide resin in which amino acid is subjected to condensation polymerization.

The molecular weight of the polyamide resin to be used in the present invention is not particularly limited, but for example, is preferably 5000 to 100000, and particularly preferably 8000 to 50000. When the molecular weight is lower than the above-described range, good formability is obtained but the mechanical strength of a film is low. When the molecular weight is higher than the above-described range, high viscosity is provided and as a result, movement of solder or tin is inhibited to cause poor conductivity.

The polyamide resin to be used in the present invention may be soluble or insoluble in solvents, but is more preferably soluble in solvents since varnish can be easily obtained at the time of mixing with other components and it is excellent in handleability.

The polyester resin to be used in the present invention is not particularly limited, but means a saturated polyester resin obtained using a divalent acid (e.g., terephthalic acid) or a derivative thereof having ester-forming ability as an acid component, and using glycol having 2 to 10 carbon atoms, another divalent alcohol, a derivative thereof having ester-forming ability or the like as a glycol component.

Examples of the polyester resin include polyalkylene terephthalate resins such as polyethylene terephthalate resin, polybutyrene terephthalate resin, polytrimethylene terephthalate resin and polyhexamethylene terephthalate resin.

The polyester resin may be a polyester resin in which another component is subjected to copolymerization according to need. The aforementioned component to be copolymerized is not particularly limited, and examples thereof include publicly-known acid components, alcohol components, phenol components or derivatives thereof having ester-forming ability, and polyalkylene glycol components.

Examples of copolymerizable acid components include divalent or higher aromatic carboxylic acid having 8 to 22 carbon atoms, divalent or higher aliphatic carboxylic acid having 4 to 12 carbon atoms, divalent or higher alicyclic carboxylic acid having 8 to 15 carbon atoms and derivatives thereof having ester-forming ability. Specific examples of the copolymerizable acid components include terephthalic acid, isophthalic acid, naphthalenedicarboxylic acid, bis(p-carbadiphenyl)methaneanthracenedicarboxylic acid, 4-4'-diphenylcarboxylic acid, 1,2-bis(phenoxy)ethane-4,4'-dicarboxylic acid, 5-sodium sulfoisophthalic acid, adipic acid, sebacic acid, azelaic acid, dodecanedioic acid, maleic acid, trimesic acid, trimellitic acid, pyromellitic acid, 1,3-cyclohexanedicarboxylic acid, 1,4-cyclohexanedicarboxylic acid and derivatives thereof having ester-forming ability. These acid components can be used solely or in combination.

Examples of the copolymerizable alcohol and/or phenol components include divalent or higher aliphatic alcohol having 2 to 15 carbon atoms, divalent or higher alicyclic alcohol having 6 to 20 carbon atoms, divalent or higher aromatic alcohol having 6 to 40 carbon atoms, or derivatives thereof having phenol- and ester-forming ability. Specific examples of the copolymerizable alcohol and/or phenol components include compounds such as ethylene glycol, propanediol,

butanediol, hexanediol, decanediol, neopentylglycol, cyclohexanedimethanol, cyclohexanediol, 2,2'-bis(4-hydroxyphenyl)propane, 2;2'-bis(4-hydroxyeyclohexyl)propane, hydroquinone, glycerin, pentaerythritol, and derivatives thereof having ester-forming ability, and cyclic esters such as ε-caprolactone.

Examples of the copolymerizable polyalkylene glycol components include polyethylene glycol, polypropylene glycol, polytetramethylene glycol, and random or block copolymers thereof, and modified polyoxyalkylene glycol such as alkylene glycol (polyethylene glycol, polypropylene glycol, polytetramethylene glycol, and random or block copolymer thereof, or the like) adducts of bisphenol compounds.

In the present invention, as such a film-forming resin component, a commercially-available product can be used. Moreover, within a range in which the effects of the present invention are not reduced, it is also possible to use a film-forming resin component in which various additives such as a plasticizing agent, a stabilizing agent, an inorganic filler, an antistatic agent and a pigment are blended.

In the conductive connecting material to be used in the present invention, the amount of the film-forming resin component can be suitably set depending on the form of the curable resin composition to be used.

For example, in the case of the curable resin composition in the solid form, the amount of the film-forming resin component is preferably 1 part by weight or more, more preferably 5 parts by weight or more, and particularly preferably 10 parts by weight or more per 100 parts by weight of the conductive connecting material. Further, it is preferably 70 parts by weight or less, more preferably 60 parts by weight or less, and particularly preferably 50 parts by weight or less. Further, the amount of the film-forming resin component is preferably 1 wt% or more, more preferably 5 wt% or more, and particularly preferably 10 wt% or more with respect to the total weight of the curable resin composition. Further, it is preferably 70 wt% or less, more preferably 60 wt% or less, and particularly preferably 50 wt% or less. When the amount of the film-forming resin component is within the above-described range, flowability of the curable resin composition before melted can be suppressed, and it becomes possible to easily handle the conductive connecting material.

(iii) Compound having a flux function

The compound having a flux function to be used in the present invention has the function to reduce an oxide layer on the surface of a terminal and a metal foil. As such a compound having a flux function, a compound having a phenolic hydroxyl group and/or a carboxyl group is preferred. Examples of compounds having a phenolic hydroxyl group include: monomers containing a phenolic hydroxyl group such as phenol, o-cresol, 2,6-xylenol, p-cresol, m-cresol, o-ethylphenol, 2,4-xylenol, 2,5-xylenol, m-ethylphenol, 2,3-xylenol, mesitol, 3,5-xylenol, p-tert-butylphenol, catechol, p-tert-amylphenol, resorcinol, p-octylphenol, p-phenylphenol, bisphenol F, bisphenol AF, biphenol, diallyl bisphenol F, diallyl bisphenol A, trisphenol and tetrakisphenol; and resins containing a phenolic hydroxyl group such as phenol novolac resin, o-cresol novolac resin, bisphenol F novolac resin and bisphenol A novolac resin.

Examples of compounds having a carboxyl group include aliphatic acid anhydride, alicyclic acid anhydride, aromatic acid anhydride, aliphatic carboxylic acid and aromatic carboxylic acid. Examples of the aliphatic acid anhydride include succinic anhydride, polyadipic anhydride, polyazelaic anhydride and polysebacic anhydride. Examples of the alicyclic acid anhydride include methyltetrahydrophthalic anhydride, methylhexahydrophthalic anhydride, methylhymic anhydride, hexahydrophthalic anhydride, tetrahydrophthalic anhydride, trialkyltetrahydrophthalic anhydride and methylcyclohexene dicarboxylic anhydride. Examples of the aromatic acid anhydride include phthalic anhydride, trimellitic anhydride, pyromellitic anhydride, benzophenone tetracarboxylic anhydride, ethylene glycol bis-trimellitate and glycerol tris-trimellitate.

Examples of the aliphatic carboxylic acid include formic acid, acetic acid, propionic acid, butyric acid, valeric acid, pivalic acid, caproic acid, caprylic acid, lauric acid, myristic acid, palmitic acid, stearic acid, acrylic acid, methacrylic acid, crotonic acid, oleic acid, fumaric acid, maleic acid, oxalic acid, malonic acid, succinic acid, glutaric acid, adipic acid, sebacic acid, dodecanedioic acid and pimelic acid. Among them, an aliphatic carboxylic acid represented by the following formula (1) is preferred:

$$HOOC\text{-}(CH_2)n\text{-}COOH\cdots\cdots \qquad (1)$$

(wherein n is an integer from 1 to 20). Adipic acid, sebacic acid and dodecanedioic acid are more preferred.

The structure of aromatic carboxylic acid is not particularly limited, but a compound represented by the following formula (2) or (3) is preferred:

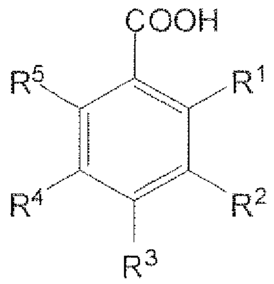

(2)

(wherein $R^1$ to $R^5$ are each independently a monovalent organic group and at least one of $R^1$ to $R^5$ is a hydroxyl group.)

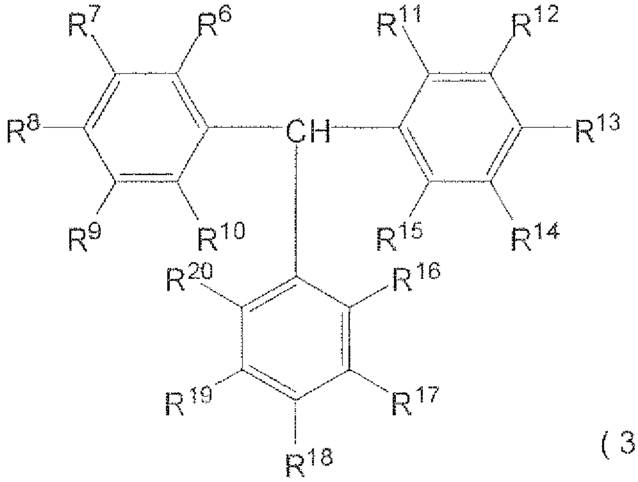

(3)

(wherein $R^6$ to $R^{20}$ are each independently a monovalent organic group and at least one of $R^6$ to $R^{20}$ is a hydroxyl group or carboxyl group.)

Examples of the aromatic carboxylic acid include: benzoic acid, phthalic acid, isophthalic acid, terephthalic acid, hemimellitic acid, trimellitic acid, trimesic acid, mellophanic acid, prehnitic acid, pyromellitic acid, mellitic acid, triyl acid, xylic acid, hemellitic acid, mesitylene acid, prehnitylic acid, toluic acid, cinnamic acid, salicylic acid, 2,3-dihydroxybenzoic acid, 2,4-dihydroxybenzoic acid, gentisic acid (2,5-dihydroxybenzoic acid), 2,6-dihydroxybenzoic acid, 3,5-dihydroxybenzoic acid, gallic acid (3,4,5-trihydroxybenzoic acid), naphthoic acid derivatives such as 4-dihydroxy-2-naphthoic acid, 3,5-dihydroxy-2-naphthoic acid, and 3,5-2-dihydroxy-2-naphthoic acid; phenolphthalin; and diphenolic acid.

Among such compounds having a flux function, more preferred is a compound which actions as a curing agent for the curable resin component, that is, a compound, which has the function to reduce an oxide layer on the surface of a metal foil and a terminal so as to enable electrical connection between the metal foil and the terminal, and which has a functional group that can be reacted with the curable resin component. The functional group can be suitably selected depending on the type of the curable resin component. For example, in the case where the curable resin component is an epoxy resin, examples of the functional group include those which can be reacted with an epoxy group such as a carboxyl group, a hydroxyl group and an amino group. The compound having the flux function reduces surface oxide films of a metal foil and a terminal at the time of melting of the conductive connecting material to improve wettability on surfaces thereof, and conductive areas are easily formed. As a result, it becomes possible to provide electrical connection between terminals or to produce connecting terminals. Further, after electrical connection between terminals is completed, the compound actions as a curing agent, and can be added to the curable resin component to increase an elastic modulus or Tg of resin. Therefore, when using the compound having the flux function as a flux, flux washing is not necessary and generation of ion migration caused by flux residue can be suppressed.

Examples of the compound having the flux function having the above-described action include a compound

having at least one carboxyl group. For example, when the curable resin component is an epoxy resin, examples of the compound includes aliphatic dicarboxylic acid and compounds having a carboxyl group and a phenolic hydroxyl group. The aforementioned aliphatic dicarboxylic acid is not particularly limited, and examples thereof include a compound in which two carboxyl groups bind to an aliphatic hydrocarbon group. The aforementioned aliphatic hydrocarbon group may be saturated or unsaturated acyclic, or may be saturated or unsaturated cyclic. When the aliphatic hydrocarbon group is acyclic, it may be linear or branched.

Examples of the aliphatic dicarboxylic acid include a compound represented by the aforementioned formula (1), wherein n is an integer from 1 to 20. When n in the formula (1) is within the aforementioned range, flux activity, outgas at the time of adhesion, and the balance between the coefficient of elasticity and glass transition temperature after the conductive connecting material is cured are favorable. In particular, in terms of the points that increase of the coefficient of elasticity after the conductive connecting material is cured can be suppressed and that the ability to adhere to a material can be improved, n is preferably 3 or higher. In terms of the points that decrease of coefficient of elasticity can be suppressed and that connection reliability can be further improved, n is preferably 10 or lower.

Examples of the aliphatic dicarboxylic acid represented by the aforementioned formula (1) include glutaric acid, adipic acid, pimelic acid, suberic acid, azelaic acid, sebacic acid, undecanedioic acid, dodecanedioic acid, tridecanedioic acid, tetradecanedioic acid, pentadecanedioic acid, octadecanedioic acid, nonadecanedioic acid, and eicosanedioic acid. Among them, adipic acid, suberic acid, sebacic acid, and dodecanedioic acid are preferred, and sebacic acid is particularly preferred.

Examples of the aforementioned compound having a carboxyl group and a phenolic hydroxyl group include: benzoic acid derivatives such as salicylic acid, 2,3-dihydroxybenzoic acid, 2,4-dihydroxybenzoic acid, gentisic acid (2,5-dihydroxybenzoic acid), 2,6-dihydroxybenzoic acid, 3,4-dihydroxybenzoic acid, and gallic acid (3,4,5-trihydroxybenzoic acid); naphthoic acid derivatives such as 1,4-dihydroxy-2-naphthoic acid and 3,5-dihydroxy-2-naphthoic acid; phenolphthalin; and diphenolic acid. Among the above-described substances, phenolphthalin, gentisic acid, 2,4-dihydroxybenzoic acid and 2,6-dihydroxybenzoic acid are preferred, and phenolphthalin and gentisic acid are particularly preferred.

In the present invention, the compounds having the flux function may be used solely or in combination. Further, since any of the compounds has high moisture absorption and causes voids, in the present invention, such a compound is preferably dried before use.

In the conductive connecting material to be used in the present invention, the amount of the compound having the flux function can be suitably set depending on the form of the resin composition to be used.

For example, in the case of the resin composition in the liquid form, the amount of the compound having the flux function is preferably 1 part by weight or more, more preferably 2 parts by weight or more, and particularly preferably 3 parts by weight or more per 100 parts by weight of the conductive connecting material. Further, it is preferably 40 parts by weight or less, more preferably 30 parts by weight or less, and particularly preferably 25 parts by weight or less. Further, the amount of the compound having the flux function is preferably 1 wt% or more, more preferably 2 wt% or more, and particularly preferably 3 wt% or more with respect to the total weight of the curable resin composition. Further, it is preferably 40 wt% or less, more preferably 30 wt% or less, and particularly preferably 25 wt% or less.

In the case of the resin composition in the solid form, the amount of the compound having the flux function is preferably 0.5 part by weight or more, more preferably 1 part by weight or more, and particularly preferably 2 part by weight or more per 100 parts by weight of the conductive connecting material. Further, it is preferably 40 parts by weight or less, more preferably 30 parts by weight or less, and particularly preferably 25 parts by weight or less. Further, the amount of the compound having the flux function is preferably 0.5 wt% or more, more preferably 1 wt% or more, and particularly preferably 2 wt% or more with respect to the total weight of the curable resin composition. Further, it is preferably 40 wt% or less, more preferably 30 wt% or less, and particularly preferably 25 wt% or less.

When the amount of the compound having the flux function is within the aforementioned range, surface oxide films of a metal foil and a terminal can be removed so as to enable electrical joining. In addition, when the resin composition is a curable resin, the compound can be efficiently added to the resin at the time of curing to enable increase of an elastic modulus or Tg of the resin. Moreover, generation of ion migration caused by an unreacted compound having the flux function can be suppressed.

The curable resin composition to be used in the present invention preferably comprises a curing accelerator. By the addition of the curing accelerator, a curable resin composition having the aforementioned melt viscosity and the aforementioned insulation resistance value can be easily obtained.

Examples of the curing accelerator include imidazole and imidazole compounds such as 2-methylimidazole, 2-undecylimidazole, 2-heptadecylimidazole, 1,2-dimethylimidazole, 2-ethyl-4-methylirnidazole, 2-phenylimidazole, 2-phenyl-4-methylimidazole, 1-benzyl-2-phenylimidazole, 1-benz-yl-2-methylimidazole, 1-cyanoethyl-2-methylimidazole, 1-cyanoethyl-2-ethyl-4-methylimidazole, 1-cyanoethyl-2-undecylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl (1')]-ethyl-s-triazine, 2,4-diamino-6-[2'-undecylimidazolyl(1')]-ethyl-s-triazinc, 2,4-diamino-6-[2'-ethyl-4-methylimidazolyl(1')]-ethyl-s-triazine, an isocyanuric acid adduct of 2,4-diamino-6-[2'-methylimidazolyl(1')]-ethyl-s-triazine, an isocyanuric acid adduct of 2-phenylimidazole, an isocyanuric acid adduct of 2-methylimidazole, 2-phenyl-4,5-dlhydroxydimethylimidazole and 2-phenyl-4-methyl-5-hydroxymethylimidazole.

Among them, in terms of the points that solder or tin can move to terminal surfaces before curing of the curable resin composition is completed, and that good connection between terminals can be obtained and connecting terminals can be produced, an imidazole compound having a melting point of 150°C or higher is preferred. Examples of the imidazole compound having a melting point of 150°C or higher include 2-phenylimidazole, 2-phenyl-4-methylimidazole, 1-cyanoethyl-2-phenylimidazole, 2,4-diamino-6-[2'-methylimidazolyl(1')]methyl-s-triazine, 2,4-diamino-6-[2'-undecylimidazolyl(1')]-ethyl-s-triazine, 2,4-diamino-6-[2'-ethyl-4-methylimidazolyl(1')]-ethyl-s-triazine, an isocyanuric acid adduct of 2,4-diamino-6-[2'-methylimidazolyl(1')]-ethyl-s-triazine, an isocyanuric acid adduct of 2-phenylimidazole, 2-phenyl-4,5-dihydroxydimethylimidazole, and 2-phenyl-4-methyl-5-hydroxymethylimidazole. Further, in the present invention, these curing accelerators can be used solely or in combination.

In the conductive connecting material of the present invention, the amount of the curing accelerator can be suitably set depending on the type of the curing accelerator to be used.

For example, when using an imidazole compound, the amount of the imidazole compound is preferably 0.001 part by weight or more, more preferably 0.003 part by weight or more, and particularly preferably 0.005 part by weight or more per 100 parts by weight of the conductive connecting material. Further, it is preferably 1.0 part by weight or less, more preferably 0.7 part by weight or less, and particularly preferably 0.5 part by weight or less. Further, the amount of the imidazole compound is preferably 0.001 wt% or more, more preferably 0.003 wt% or more, and particularly preferably 0.005 wt% or more with respect to the total weight of the curable resin composition. Further, it is preferably 1.0 wt% or less, more preferably 0.7 wt% or less, and particularly preferably 0.5 wt% or less. When the amount of the imidazole compound is less than the aforementioned lower limit, the effects as the curing accelerator are not sufficiently exerted and the curable resin composition tends to be not sufficiently cured. When the amount of the imidazole compound is more than the aforementioned upper limit, solder or tin does not move to terminal surfaces sufficiently before curing of the curable resin composition is completed and the insulation property tends to be not sufficiently ensured due to remaining of solder or tin at insulating areas. In addition, preservability of the conductive connecting material tends to be reduced.

(iv) Other additives

The curable resin composition to be used in the present invention may further comprise a curing agent (excluding those acting as a flux) and a silane coupling agent. In addition, in the curable resin composition, various additives may be suitably blended in order to improve various properties such as compatibility, stability and workability of respective components.

Examples of curing agents other than compounds having the flux function include phenols, amines and thiols. Such curing agents can be suitably selected depending on the type of the curable resin component, etc. For example, when using en epoxy resin as the curable resin component, as the curing agent, phenols are preferably used from the viewpoint of good reactivity with epoxy resin, small change in size at the time of curing, and suitable physical properties after curing (e.g., heat resistance and moisture resistance). In terms of excellent physical properties of the curable resin component after curing, phenols are more preferably bifunctional or higher. Further, such curing agents may be used solely or in combination.

Examples of such phenols include bisphenol A, tetramethyl bisphenol A, diallyl bisphenol A, biphenol, bisphenol F, diallyl bisphenol F, trisphenol, tetrakisphenol, phenol novolac resin, and cresol novolac resin. Among them, phenol novolac resin and cresol novolac resin are preferably used because they have good melt viscosity and reactivity with epoxy resin and have excellent physical properties after curing.

In the conductive connecting material of the present invention, the amount of the curing agent can be suitably selected depending on the types of the curable resin component and the curing agent to be used, and if the compound having the flux function has a functional group that functions as a curing agent, depending on the type and amount of the functional group.

For example, when using a phenol novolac resin, the amount thereof is preferably 1 part by weight or more, more preferably 3 parts by weight or more, and particularly preferably 5 parts by weight or more per 100 parts by weight of the conductive connecting material. Further, it is preferably 50 parts by weight or less, more preferably 40 parts by weight or less, and particularly preferably 30 parts by weight or less. Further, the amount of the phenol novolac resin is preferably 1 wt% or more, more preferably 3 wt% or more, and particularly preferably 5 wt% or more with respect to the total weight of the curable resin composition. Further, it is preferably 50 wt% or less, more preferably 40 wt% or less, and particularly preferably 30 wt% or less. When the amount of the phenol novolac resin is within the aforementioned lower limit, the curable resin component tends to be not sufficiently cured. When the amount exceeds the upper limit, ion migration tends to be easily generated due to remaining of unreacted phenol novolac resin.

When using en epoxy resin as the curable resin component, the amount of the phenol novolac resin may be

defined by the equivalent ratio with respect to the epoxy resin. For example, the equivalent ratio of phenol novalac resin to epoxy resin is preferably 0.5 to 1.2, more preferably 0.6 to 1.1, and particularly preferably 0.7 to 0.98. When the equivalent ratio is lower than the aforementioned lower limit, heat resistance and moisture resistance of the epoxy resin after curing tend to be easily reduced. When the equivalent ratio exceeds the aforementioned upper limit, ion migration tends to be easily generated due to remaining of unreacted phenol novolac resin.

Examples of the silane coupling agent include an epoxysilane coupling agent and an aromatic ring-containing aminosilane coupling agent. By the addition of the silane coupling agent, adhesion between a joint member and the conductive connecting material can be improved. Further, these silane coupling agents may be used solely or in combination.

In the conductive connecting material of the present invention, the amount of the silane coupling agent can be suitably selected depending on the types of joint member, curable resin component, etc. For example, the amount is preferably 0.01 part by weight or more, more preferably 0.05 part by weight or more, and particularly preferably 0.1 part by weight or more per 100 parts by weight of the curable resin composition. Further, it is preferably 2 parts by weight or less, more preferably 1.5 parts by weight or less, and particularly preferably 1 part by weight or less. That is, the amount of the silane coupling agent is preferably 0.01 wt% or more, more preferably 0.05 wt% or more, and particularly preferably 0.1 wt% or more with respect to the total weight of the curable resin composition. Further, it is preferably 2 wt% or less, more preferably 1.5 wt% or less, and particularly preferably 1 wt% or less.

In the present invention, the aforementioned curable resin composition can be prepared by mixing/dispersion of the above-described components. Methods for mixing and dispersing respective components are not particularly limited, and mixing and dispersion can be performed according to conventionally known methods.

Further, in the present invention, the curable resin composition in the liquid form may be prepared by mixing the aforementioned components in a solvent or in the absence of solvent. The solvent to be used is not particularly limited as long as it is inactive against respective components. Examples thereof include: ketones such as acetone, methyl ethyl ketone (MEK), methyl isobutyl ketone (MIBK), diisobutyl ketone (DIBK), cyclohexanone and diacetone alcohol (DAA); aromatic hydrocarbons such as benzene, xylene and toluene; alcohols such as methyl alcohol, ethyl alcohol, isopropyl alcohol and n-butyl alcohol; cellosolve-based substances such as methyl cellosolve, ethyl cellosolve, butyl cellosolve, methyl cellosolve acetate and ethyl cellosolve acetate; N-methyl-2-pyrrolidone (NMP); tetrahydrofuran (THF); dimethylformamide (DMF); dibasic ester (DBE); ethyl 3-ethoxypropionate (EEP); and dimethyl carbonate (DMC). Further, the use amount of the solvent is preferably within the range in which the solid content concentration of the components mixed in the solvent is 10 to 60 wt%.

(b) Thermoplastic resin composition

In the present invention, a thermoplastic resin composition may also be used as the resin composition.
The thermoplastic resin composition to be used in the present invention is not particularly limited as long as it comprises a thermoplastic resin component and a compound having a flux function and is softened at a predetermined temperature. Further, particularly preferably, the thermoplastic resin composition has a predetermined melt viscosity at the time of heating in the heating step. For example, the melt viscosity of the thermoplastic resin composition at the melting point of the metal foil is preferably 100 Pa·s or less, more preferably 50 Pa·s or less, and even more preferably 10 Pa·s or less. Further, it is preferably 0.001 Pa·s or more, more preferably 0.005 Pa·s or more, and even more preferably 0.01 Pa·s or more. Examples of the thermoplastic resin composition include a hot-melt-type adhesive and a reactive hot-melt adhesive.

(i) Thermoplastic resin component

The aforementioned thermoplastic resin component is not particularly limited, and examples thereof include vinyl acetate-based substances, polyvinyl alcohol resin, polyvinyl butyral resin, vinyl chloride resin, (meth)acrylic resin, phenoxy resin, polyester resin, polyimide resin, polyamide-imide resin, siloxane-modified polyimide resin, polybutadiene resin, acrylic resin, styrene resin, polyethylene resin, polypropylene resin, polyamide resin, cellulose resin, isobutylene resin, vinyl ether resin, liquid crystal polymer resin, polyphenylene sulfide resin, polyphenylene ether resin, polyethersulfone resin, polyetherimide resin, poly(ether ether ketone) resin, polyurethane resin, styrene-butadiene-styrene copolymer, styrene-ethylene-butylene-styrene copolymer, polyacetal resin, polyvinyl butyral resin, polyvinyl acetal resin, butyl rubber, chloroprene rubber, acrylonitrile-butadiene copolymer, acrylonitrile-butadiene-acrylic acid copolymer, acrylonitrile-butadiene-styrene copolymer, and polyvinyl acetate. The thermoplastic resin component may be a single polymer or a copolymer consisting of at least 2 of the above-described thermoplastic resin components.

The softening point of the aforementioned thermoplastic resin component is not particularly limited. However, when compared to the melting point of the metal foil constituting the conductive connecting material, the softening point is preferably 10°C or more lower, particularly preferably 20°C or more lower, and more preferably 30°C or more lower.

The decomposition temperature of the thermoplastic resin component is not particularly limited. However, when compared to the melting point of the metal foil constituting the conductive connecting material, the decomposition temperature is preferably 10°C or more higher, particularly preferably 20°C or more higher, and more preferably 30°C or more higher.

In the conductive connecting material to be used in the present invention, the amount of the thermoplastic resin component can be suitably set depending on the form of the thermoplastic resin composition to be used.

For example, in the case of the thermoplastic resin composition in the liquid form, the amount of the thermoplastic resin component is preferably 10 parts by weight or more, more preferably 15 parts by weight or more, even more preferably 20 parts by weight or more, still more preferably 25 parts by weight or more, still even more preferably 30 parts by weight or more, and particularly preferably 35 parts by weight or more per 100 parts by weight of the conductive connecting material. Further, it is preferably 100 parts by weight or less, more preferably 95 parts by weight or less, even more preferably 90 parts by weight or less, still more preferably 75 parts by weight or less, still even more preferably 65 parts by weight or less, and particularly preferably 55 parts by weight or less. Further, the amount of the thermoplastic resin component is preferably 10 wt% or more, more preferably 15 wt% or more, even more preferably 20 wt% or more, still more preferably 25 wt% or more, still even more preferably 30 wt% or more, and particularly preferably 35 wt% or more with respect to the total weight of the thermoplastic resin composition. Further, it is preferably 100 wt% or less, more preferably 95 wt% or less, even more preferably 90 wt% or less, still more preferably 75 wt% or less, still even more preferably 65 wt% or less, and particularly preferably 55 wt% or less.

In the case of the thermoplastic resin composition in the solid form, the amount of the thermoplastic resin component is preferably 5 parts by weight or more, more preferably 10 parts by weight or more, even more preferably 15 parts by weight or more, and particularly preferably 20 parts by weight or more per 100 parts by weight of the conductive connecting material. Further, it is preferably 90 parts by weight or less, more preferably 85 parts by weight or less, even more preferably 80 parts by weight or less, still more preferably 75 parts by weight or less, still even more preferably 65 parts by weight or less, and particularly preferably 55 parts by weight or less. Further, the amount of the thermoplastic resin component is preferably 5 wt% or more, more preferably 10 wt% or more, even more preferably 15 wt% or more, and particularly preferably 20 wt% or more with respect to the total weight of the thermoplastic resin composition. Further, it is preferably 90 wt% or less, more preferably 85 wt% or less, even more preferably 80 wt% or less, still more preferably 75 wt% or less, still even more preferably 65 wt% or less, and particularly preferably 55 wt% or less.

When the amount of the thermoplastic resin component is within the aforementioned range, the electrical connection strength and the mechanical adhesion strength between terminals can be ensured sufficiently.

(ii) Compound having the flux function

As the compound having the flux function, the same compounds as those explained in "(a) Curable resin composition" can be used. The same also applies to the preferred compound and the amount.

(iii) Other additives

In addition, in the above-described thermoplastic resin component, a silane coupling agent, a plasticizing agent, a stabilizing agent, a tackifier, an activating agent, an antioxidant, an inorganic filler, a filler, an antistatic agent, a pigment, etc. can be blended within a range in which the effects of the present invention are not reduced.

In the conductive connecting material of the present invention, the amount of the aforementioned curable resin composition or thermoplastic resin composition can be suitably set depending on the form of the resin composition to be used.

For example, in the case of the resin composition in the liquid form, the amount of the aforementioned curable resin composition or thermoplastic resin composition is preferably 10 parts by weight or more, more preferably 20 parts by weight or more, and particularly preferably 25 parts by weight or more per 100 parts by weight of the conductive connecting material. Further, it is preferably 95 parts by weight or less, more preferably 80 parts by weight or less, and particularly preferably 75 parts by weight or less. That is, the amount of the aforementioned curable resin composition or thermoplastic resin composition is preferably 10 wt% or more, more preferably 20 wt% or more, and particularly preferably 25 wt% or more with respect to the total weight of the conductive connecting material. Further, it is preferably 95 wt% or less, more preferably 80 wt% or less, and particularly preferably 75 wt% or less.

In the case of the resin composition in the solid form, the amount of the aforementioned curable resin composition or thermoplastic resin composition is preferably 10 parts by weight or more, more preferably 15 parts by weight or more, and particularly preferably 20 parts by weight or more per 100 parts by weight of the conductive connecting material. Further, it is preferably 95 parts by weight or less, more preferably 80 parts by weight or less, and particularly preferably 75 parts by weight or less. That is, the amount of the aforementioned curable resin composition or thermoplastic resin composition is preferably 10 wt% or more, more preferably 15 wt% or more, and particularly preferably 20 wt% or more

with respect to the total weight of the conductive connecting material. Further, it is preferably 95 wt% or less, more preferably 80 wt% or less, and particularly preferably 75 wt% or less.
When the amount of the resin composition is within the aforementioned range, the electrical connection strength and the mechanical adhesion strength between connecting members can be ensured sufficiently.

In the conductive connecting material of the present invention, the thickness of each of resin composition layers is not particularly limited, but is preferably 1 μm or more, more preferably 3 μm or more, and particularly preferably 5 μm or more. Further, the thickness of the resin composition layer is preferably 200 μm or less, more preferably 150 μm or less, and particularly preferably 100 μm or less. When the thickness of the resin composition layer is within the aforementioned range, a gap between adjacent terminals can be sufficiently filled with the resin composition, the mechanical adhesion strength after curing/solidifying of the resin composition and the electrical connection between opposed terminals can be ensured sufficiently, and it is also possible to produce connecting terminals.

When the conductive connecting material of the present invention comprises a plurality of resin composition layers, compositions of respective resin composition layers may be the same or different depending on differences of the type of a resin component to be used, formulation, etc. Physical properties such as melt viscosity and softening temperature of respective resin composition layers may also be the same or different. For example, the resin composition layer in the liquid form and the resin composition layer in the solid form may be used in combination.

(2) Metal foil layer

In the present invention, the metal foil layer is a layer constituted by a metal foil selected from a solder foil and a tin foil. It is sufficient when the metal foil layer is formed on at least a portion of the resin composition layer in a planar view. The metal foil layer may also be formed on the entire surface of the resin composition layer.

The shape of the metal foil layer is not particularly limited. A predetermined shape may be formed in a repeated pattern, or the shape may be irregular. A regular shape and an irregular shape may coexist. Figure 7 is a plan view showing one example of the shape of the metal foil layer. Metal foil layers 110 having various shapes are formed on resin composition layers 120. Examples of the shape of the metal foil layer include (a) a dotted line-like hole pattern, (b) a stripe pattern, (c) a polka-dot pattern, (d) a rectangle pattern, (e) a checker pattern, (f) a frame pattern, (g) a lattice pattern and (h) a multiple frame pattern as shown in Figure 7. These shapes are a part of examples and may be combined or modified depending on purposes and applications.

In one embodiment of the present invention, when the diameter of each of terminals to be connected or electrode for producing a connecting terminal is more than 0.5 mm and the pitch of the terminal or electrode is less than 1 mm, in order to facilitate connection between terminals or production of the connecting terminal, it is preferred to form a sheet-like metal foil layer on the entire surface of the resin composition layer.

When the diameter of the terminal or electrode is less than 1 mm and the pitch of the terminal or electrode is more than 3 mm, from the viewpoint of effective utilization of metal foil and prevention of remaining of solder or tin between adjacent terminals or connecting terminals, it is preferred to form a metal foil layer on at least a portion of the resin composition layer in a repeated pattern. In this case, the shape of the metal foil layer can be suitably selected depending on the pitch, form, etc. of the terminal or connecting terminal.

The metal foil to be used in the present invention is not particularly limited as long as it has a surface oxide film that can be removed by the reduction of the compound having the flux function, but the metal foil is preferably made of: an alloy of at least 2 types of metals selected from the group consisting of tin (Sn), lead (Pb), silver (Ag), bismuth (Bi), indium (In), zinc (Zn), nickel (Ni), antimony (Sb), iron (Fe), aluminium (Al), gold (Au), germanium (Ge) and copper (Cu); or tin alone.

Among such alloys, in consideration of melting temperature and mechanical properties, alloys containing Sn such as Sn-Pb alloy, Sn-Bi alloy, Sn-Ag-Cu alloy, Sn-In alloy and Sn-Ag alloy that is lead-free solder are more preferred. In the case of Sn-Pb alloy, the tin content is preferably 30 wt% or more and less than 100 wt%, more preferably 35 wt% or more and less than 100 wt%, and particularly preferably 40 wt% or more. Further, it is preferably less than 100 wt%. Further, the tin content of lead-free solder is preferably 15 wt% or more and less than 100 wt%, more preferably 20 wt% or more and less than 100 wt%, and particularly preferably 25 wt% or more and less than 100 wt%. Examples of Sn-Pb alloy include Sn63-Pb (melting point: 183°C), and examples of lead-free solder include Sn-3.0Ag-0.5Cu (melting point: 217°C), Sn-3.5Ag (melting point: 221°C), Sn-58Bi (melting point: 139°C), Sn-9.0Zn (melting point: 199°C), Sn-3.5Ag-0.5Bi-3.0In (melting point: 193°C) and Au-20Sn (melting point: 280°C).

In the present invention, a metal foil having a desired melting point and composition can be suitably used depending on heat resistance of an electronic member and a semiconductor device to be connected. For example, regarding connection between terminals in a semiconductor device, in order to prevent damage of members of the semiconductor device due to heat history, it is preferred to use a metal foil having a melting point of 330°C or lower (more preferably 300°C or lower, particularly preferably 280°C or lower, and more preferably 260°C or lower). In addition, in order to ensure heat resistance of the semiconductor device after connection between terminals, it is preferred to use

a metal foil having a melting point of 100°C or higher (more preferably 110°C or higher, and particularly preferably 120°C or higher). The melting point of the metal foil can be measured using a differential scanning calorimeter (DSC).

The thickness of the aforementioned metal foil can be suitably selected depending on the gap between opposed terminals, the distance between adjacent terminals, etc. For example, in the case of connection between respective connecting terminals of a semiconductor chip, substrate, semiconductor wafer, etc. in a semiconductor device, the thickness of the metal foil is preferably 0.5 μm or more, more preferably 3 μm or more, and particularly preferably 5 μm or more. Further, the thickness is preferably 100 μm or less, more preferably 50 μm or less, and particularly preferably 20 μm or less. When the thickness of the metal foil is less than the aforementioned lower limit, the number of unconnected terminals tends to be increased due to lack of solder or tin. When the thickness is more than the aforementioned upper limit, shorting circuit tends to easily occur because of occurring of bridging between adjacent terminals due to excess solder or tin.

The method for preparing the metal foil (metal layer) is not particularly limited, and examples thereof include a method in which the metal foil is prepared by rolling of mass of ingot or the like and a method in which a metal foil layer is formed by direct evaporation, sputtering, plating or the like to the resin composition layer. Further, the method for preparing the metal foil in a repeated pattern is not particularly limited, but examples thereof include a method in which a predetermined pattern is punched out in a metal foil, a method for forming a predetermined pattern by etching or the like, and a method in which the metal foil is formed by evaporation, sputtering, plating, etc. using a shielding plate, mask or the like.

In the conductive connecting material to be used in the present invention, the amount of the metal foil is preferably 5 parts by weight or more, more preferably 20 parts by weight or more, and particularly preferably 30 parts by weight or more per 100 parts by weight of the conductive connecting material. Further, it is preferably less than 100 parts by weight, more preferably 80 parts by weight or less, and particularly preferably 70 parts by weight or less. That is, the amount of the metal foil is preferably 5 wt% or more, more preferably 20 wt% or more, and particularly preferably 30 wt% or more with respect to the total weight of the conductive connecting material. Further, it is preferably less than 100 wt%, more preferably 80 wt% or less, and particularly preferably 70 wt% or less. When the amount of the metal foil is less than the aforementioned lower limit, the number of unconnected terminals tends to be increased due to lack of solder or tin. When the amount is more than the aforementioned upper limit, bridging between adjacent terminals tends to easily occur due to excess solder or tin.

Alternatively, the amount of the metal foil may be defined by the volume ratio with respect to the conductive connecting material. For example, the amount of the metal foil is preferably 1% by volume or more, more preferably 5% by volume or more, and particularly preferably 10% by volume or more with respect to the conductive connecting material. Further, it is preferably 90% by volume or less, more preferably 80% by volume or less, and particularly preferably 70% by volume or less. When the amount of the metal foil is less than the aforementioned lower limit, the number of unconnected terminals tends to be increased due to lack of solder or tin. When the amount is more than the aforementioned upper limit, bridging between adjacent terminals tends to easily occur due to excess solder or tin.

(3) Form of conductive connecting material

In the present invention, the form of the conductive connecting material can be suitably selected depending on the form of the resin composition, etc. For example, in the case of the resin composition in the liquid form, a product in which the resin composition is applied to both sides of the metal foil, or a product in which the resin composition is applied to the surface of a release substrate such as a polyester sheet, drying and film forming are performed at a predetermined temperature for the purpose of semi-curing (B-stage), etc., and after that the metal foil is attached thereto to form a film, etc., can be provided as the conductive connecting material. In the case of the resin composition in the solid form, a product in which a varnish of the resin composition dissolved in an organic solvent is applied to the surface of a release substrate such as a polyester sheet, drying is performed at a predetermined temperature, and after that the metal foil is attached thereto or subjected to evaporation or the like to form a film, can be provided as the conductive connecting material.

In addition, the conductive connecting material and the metal foil to be used therein in the present invention can be embossed in order to enhance contact to terminals.

The thickness of the conductive connecting material of the present invention is not particularly limited, but is preferably 1 μm or more, more preferably 3 μm or more, and particularly preferably 5 μm or more. Further, it is preferably 200 μm or less, more preferably 150 μm or less, and particularly preferably 100 μm or less. When the thickness of the conductive connecting material is within the aforementioned range, a gap between adjacent terminals can be sufficiently filled with the resin composition. In addition, the mechanical adhesion strength after curing or solidifying of the resin component and the electrical connection between opposed terminals can be ensured sufficiently. Moreover, it is also possible to produce connecting terminals depending on purposes and applications.

Hereinafter, the method for producing the conductive connecting material will be described.

When the resin composition to be used in the present invention is in a liquid form at 25°C, for example, the metal foil is immersed in the resin composition in the liquid form to allow the resin composition in the liquid form to adhere to the both surfaces of the metal foil, thereby producing the conductive connecting material of the present invention. When it is necessary to control the thickness of the resin composition, a method in which the metal foil immersed in the resin composition in the liquid form is passed through a bar coater having a certain gap, or a method in which the resin composition in the liquid form is sprayed using a spray coater or the like can be employed.

When the resin composition is in the film form at 25°C, for example, the conductive connecting material can be produced in the manner described below. Firstly, a varnish of the resin composition dissolved in an organic solvent is applied to the surface of a release substrate such as a polyester sheet, and drying and film-forming are performed at a predetermined temperature to prepare the resin composition in the film form. Next, two films of the resin composition formed on the release substrate are prepared, and the metal foil is sandwiched between the two sheets to be subjected to lamination using a heating roller, thereby preparing a conductive connecting material having three layers in which the resin composition is placed on the both surfaces of the metal foil (resin composition/metal foil/resin composition). Further, when the resin composition is placed on one surface of the metal foil using the above-described lamination method, a conductive connecting material having two layers (resin composition/metal foil) can be prepared.

When using a rolled metal foil, the metal foil is used as a base substrate, and the aforementioned resin composition in the film form is placed on the both surfaces or one surface of the metal foil to be subjected to lamination using a heating roller, thereby obtaining a rolled conductive connecting material. In addition, when using a rolled metal foil, the resin composition in the varnish form is directly applied to the both surfaces or one surface of the metal foil and a solvent is volatilized, thereby preparing a rolled conductive connecting material.

When preparing the conductive connecting material using a metal foil in a pattern, for example, a metal foil is placed on a release substrate, the metal foil is half-cut with a die from the metal foil side, and excess metal foil is removed to prepare a metal foil in a pattern. Then, the aforementioned resin composition in the film form may be laminated thereon using a heating roller. When providing the resin composition on the both surfaces of the metal foil in the pattern, the release substrate is released, and the resin composition in the film form may be further laminated on the surface of the metal foil in the pattern opposite to the surface on which the resin composition is already formed.

Note that the method for producing the conductive connecting material is not particularly limited to the above-described methods. The method for producing the conductive connecting material can be suitably selected by those skilled in the art depending on purposes and applications.

2. Method for connecting terminals

Hereinafter, the method for connecting terminals of the present invention will be described. The connecting method of the present invention is related to the method for connecting terminals using the aforementioned conductive connecting material, and comprises: a placement step in which the conductive connecting material is placed between opposed terminals; a heating step in which the conductive connecting material is heated; and a curing/solidifying step in which the resin composition is cured or solidified. The connecting method of the present invention can be used, for example, at the time of connecting terminals formed in semiconductor wafers, semiconductor chips, rigid substrates, flexible substrates and other electrical/electronic components.

In the connecting method of the present invention, steps in the case where the resin composition of the conductive connecting material is a curable resin composition are slightly different from steps in the case where the resin composition is a thermoplastic resin composition. Hereinafter, the case where the resin composition of the conductive connecting material is a curable resin composition is designated as the first embodiment, the case where the resin composition is a thermoplastic resin composition is designated as the second embodiment, and these embodiments will be described independently.

(1) First embodiment

The method for connecting terminals in the first embodiment of the present invention comprises: a placement step in which the conductive connecting material including the curable resin composition and the metal foil is placed between opposed terminals; a heating step in which the conductive connecting material is heated at a temperature, which is equal to or higher than the melting point of the metal foil, and at which curing of the curable resin composition is not completed; and a curing step in which the curable resin composition is cured.

According to this connecting method, a conductive area can be formed by selective aggregation of heated and melted solder or tin between terminals. Further, an insulating area can be formed by the curable resin composition around the conductive area. As a result, leak current can be prevented by ensuring the insulation property between adjacent terminals, and therefore, connection reliability of the connection between the terminals can be improved. In addition, it is possible to electrically connect a plurality of terminals in a fine pitch circuit at the same time. Moreover, by

curing the curable resin composition, the mechanical strength of the conductive area or insulating area can be improved.
Hereinafter, a preferred embodiment of the method for connecting terminals of the first embodiment of the present invention will be described in detail with reference to the drawings, but the connecting method of the present invention is not limited to the drawings.

(a) Placement step

Firstly, as shown in Figure 1, a substrate 10 on which a terminal 11 is provided and a substrate 20 on which a terminal 21 is provided are positioned so that the terminal 11 is opposed to the terminal 21. A conductive connecting material 30 consisting of a metal foil 110 and a curable resin composition 120 provided on both surfaces of the metal foil 110 is placed between the terminals. At this time, as shown in Figure 3, the conductive connecting material 30 may be bonded to one or both of the substrate 10 and the substrate 20 by thermal compression in advance using a roll laminator, a pressing apparatus or the like. Further, the surfaces of the terminals 11 and may be subjected to treatments such as washing, polishing, plating and surface activation according to need in order to provide good electrical connection.

(b) Heating step

In the heating step, the conductive connecting material placed between the terminals in the aforementioned placement step is heated at a temperature, which is equal to or higher than the melting point of the metal foil, and at which curing of the curable resin composition is not completed. In this regard, "a temperature at which curing of the curable resin composition is not completed" means a temperature at which the melt viscosity of the curable resin composition is preferably 100 Pa·s or less, more preferably 50 Pa·s or less, and particularly preferably 10 Pa·s or less. However, in the connecting method of the present invention, in order to prevent bleeding of the conductive connecting material from the substrates at the time of heating, heating is performed at a temperature at which the melt viscosity of the curable resin composition is preferably 0.001 Pa·s or more, more preferably 0.005 Pa·s or more, and particularly preferably 0.01 Pa·s or more. It is sufficient when the heating temperature is equal to or higher than the melting point of the metal foil. The upper limit of the heating temperature is not particularly limited as long as it is within a range in which the above-described melt viscosity can be obtained by adjusting heating time (e.g., reducing heating time).
Specifically, the heating temperature can be suitably selected depending on compositions of the metal foil and the curable resin composition to be used, etc., but is preferably 100°C or higher, more preferably 130°C or higher, particularly preferably 140°C or higher, and most preferably 150°C or higher. In order to prevent heat deterioration of substrates, etc. to be connected, the heating temperature is preferably 260°C or lower, more preferably 250°C or lower, and particularly preferably 240°C or lower.
When heating the conductive connecting material at the temperature as described above, the metal foil 110 is melted, and melted solder or tin can move in the curable resin composition 120. By the reduction of the compound having the flux function contained in the curable resin composition, the oxide layer on the surface of solder or tin has been removed, and therefore, the wettability on solder or tin has been improved. As a result, metal binding is promoted to facilitate aggregation between opposed terminals. Meanwhile, by the reduction of the compound having the flux function, the surface oxide films of the terminals 11 and 21 have also been removed to improve wettability. Therefore, metal binding with solder or tin is enabled. As a result, as shown in Figure 2, a conductive area 130 is formed between the terminals to electrically connect the terminals 11 and 21. Meanwhile, the area surrounding the conductive area is filled with the curable resin composition to form an insulating area 140. As a result, the insulation property between adjacent terminals can be ensured, and shorting circuit between adjacent terminals can be prevented.
In the connecting method of the present invention, heating may be performed under pressure so that the distance between opposed terminals is reduced. For example, by heating and pressurizing in the direction in which the substrate 10 is opposed to the substrate 20 in Figure 1 using a means such as a publicly-known thermal compression bonding apparatus, the distance between opposed terminals can be constantly controlled, and electrical connection reliability between opposed terminals can be improved.
In addition, at the time of pressurizing or heating, ultrasonic wave or electric field may be added, or special heating such as laser and electromagnetic induction may be applied.

(c) Curing step

In the connecting method of the present invention, after the conductive area 130 and the insulating area 140 are formed in the aforementioned heating step, the curable resin composition is cured to fix the insulating area 140. By performing this, electrical reliability and mechanical connection strength between the terminals can be ensured sufficiently. Particularly in the connecting method of the present invention, because of using a curable resin composition having a high insulation resistance value at the time of a high melt viscosity, the insulation property of the insulating

area can be ensured more sufficiently.

Curing of the curable resin composition can be carried out by heating the conductive connecting material. The curing temperature of the conductive connecting material can be suitably set depending on the composition of the curable resin composition, but is preferably a temperature which is 5°C or more lower than the heating temperature in the aforementioned heating step, and particularly preferably a temperature which is 10°C or more lower. Specifically, the curing temperature is preferably 100°C or higher, more preferably 120°C or higher, particularly preferably 130°C or higher, and most preferably 150°C or higher. Further, it is preferably 300°C or lower, more preferably 260°C or lower, particularly preferably 250°C or lower, and most preferably 240°C or lower. When the curing temperature is within the aforementioned range, the conductive connecting material is not thermally decomposed, and the curable resin composition can be sufficiently cured.

(2) Second embodiment

Hereinafter, the method for connecting terminals of the second embodiment of the present invention will be described. The method for connecting terminals of the second embodiment of the present invention comprises: a placement step in which the conductive connecting material including the thermoplastic resin composition and the metal foil is placed between opposed terminals; a heating step in which the conductive connecting material is heated at a temperature, which is equal to or higher than the melting point of the metal foil, and at which the thermoplastic resin composition is softened; and a solidifying step in which the thermoplastic resin composition is solidified. Each step will be described below.

(a) Placement step

In the case of using the conductive connecting material including the thermoplastic resin composition and the metal foil, the conductive connecting material can be placed like the case of using the conductive connecting material including the thermosetting resin composition and the metal foil.

(b) Heating step

The heating step is not particularly limited, but the conductive connecting material placed between the terminals in the aforementioned placement step is heated at a temperature, which is equal to or higher than the melting point of the metal foil, and at which the aforementioned thermoplastic resin composition is softened. In this regard, "a temperature at which the thermoplastic resin composition is softened" means a temperature at which the melt viscosity of the thermoplastic resin composition is preferably 100 Pa·s or less, more preferably 50 Pa·s or less, and particularly preferably 10 Pa·s or less. However, in the connecting method of the present invention, in order to prevent bleeding of the conductive connecting material from the substrates at the time of heating, heating is performed at a temperature at which the melt viscosity of the thermoplastic resin composition is preferably 0.001 Pa·s or more, more preferably 0.005 Pa·s or more, and particularly preferably 0.01 Pa·s or more. It is sufficient when the heating temperature is equal to or higher than the melting point of the metal foil. The upper limit of the heating temperature is not particularly limited as long as it is within a range in which the above-described melt viscosity can be obtained by adjusting heating time (e.g., reducing heating time).

The heating temperature can be suitably selected depending on the compositions of the metal foil and the thermoplastic resin composition to be used, etc. For example, heating can be performed at the same temperature as that for the conductive connecting material including the curable resin composition and the metal foil.

When heating the conductive connecting material at the temperature as described above, the metal foil 110 is melted, and melted solder or tin can move in the thermoplastic resin composition 120. By the reduction of the compound having the flux function contained in the thermoplastic resin composition, the surface oxide film of solder or tin has been removed, and therefore, the wettability of solder or tin has been improved. As a result, metal binding is promoted to facilitate aggregation between opposed terminals. Meanwhile, by the reduction of the compound having the flux function, the surface oxide films of the terminals 11 and 21 have also been removed to improve wettability. Therefore, metal binding with solder or tin is enabled. As a result, as shown in Figure 2, a conductive area 130 is formed between the terminals to electrically connect the terminals 11 and 21. Meanwhile, the area surrounding the conductive area is filled with the thermoplastic resin composition to form an insulating area 140. As a result, the insulation property between adjacent terminals can be ensured, and shorting circuit between adjacent terminals can be prevented.

(c) Solidifying step

In the connecting method of the present invention, after the conductive area 130 and the insulating area 140

are formed in the aforementioned heating step, the thermoplastic resin composition is solidified to fix the insulating area 140. By performing this, electrical reliability and mechanical connection strength between the terminals can be ensured sufficiently.

Solidification of the thermoplastic resin composition can be carried out by cooling/solidifying the conductive connecting material heated and melted in the aforementioned heating step. Cooling/solidifying of the conductive connecting material can be suitably set depending on the composition of the thermoplastic resin composition and is not particularly limited. A method utilizing natural cooling may be employed. Alternatively, a method for spraying cold air or the like may also be employed.

The solidifying temperature of the thermoplastic resin composition is not particularly limited, but is preferably lower than the melting point of the metal foil. More specifically, the solidifying temperature of the thermoplastic resin composition is preferably 10°C or more lower than the melting point of the metal foil, and particularly preferably 20°C or more lower. Further, the solidifying temperature of the thermoplastic resin composition is preferably 50°C or higher, particularly preferably 60°C or higher, and more preferably 100°C or higher. When the solidifying temperature of the thermoplastic resin composition is within the above-described range, the conductive area 130 can be surely formed, and the insulating area 140 can have desired heat resistance. Therefore, the insulation property between adjacent terminals can be ensured, and shorting circuit between adjacent terminals can be more surely prevented.

Thus, by using the conductive connecting material, which consists of a resin composition containing a specific resin component and a compound having a flux function and a metal foil, solder or tin can be selectively aggregated between opposed terminals. As a result, it is possible to electrically connect terminals and to ensure the insulation property between adjacent terminals. Moreover, it is possible to conduct a plurality of terminals at the same time, and to provide connection between terminals having excellent reliability.

3. Method for producing connecting terminal

Hereinafter, the method for producing the connecting terminal of the present invention will be described.
The method for producing the connecting terminal of the present invention is related to the method for producing the connecting terminal on an electrode of an electronic member using the aforementioned conductive connecting material, and comprises: a placement step in which the conductive connecting material is placed on an electrode of an electronic member; a heating step in which the conductive connecting material is heated; and a curing/solidifying step in which the resin composition is cured or solidified. The method for producing the connecting terminal of the present invention can be used, for example, at the time of producing connecting terminals on electrodes of semiconductor wafers, semiconductor chips, rigid substrates, flexible substrates and other electrical/electronic components.

In the connecting method of the present invention, production steps for connecting terminals in the case where the resin composition of the conductive connecting material is a curable resin composition are slightly different from production steps for connecting terminals in the case where the resin composition is a thermoplastic resin composition. Hereinafter, the case where the resin composition of the conductive connecting material is a curable resin composition is designated as the first embodiment, the case where the resin composition is a thermoplastic resin composition is designated as the second embodiment, and these embodiments will be described independently.

(1) First embodiment

The method for producing the connecting terminal of the first embodiment of the present invention comprises: a placement step in which the conductive connecting material including the curable resin composition and the metal foil is placed on an electrode of an electronic member; a heating step in which the conductive connecting material is heated at a temperature, which is equal to or higher than the melting point of the metal foil, and at which curing of the curable resin composition is not completed; and a curing step in which the curable resin composition is cured.
In this method for producing the connecting terminal, it is possible to selectively aggregate heated/melted solder or tin on the electrode on the substrate to form the connecting terminal, and to form the insulating area consisting of the curable resin composition around the connecting terminal. As a result, the connecting terminal can be covered with the curable resin composition, and therefore, the conductive area is fixed. In addition, since the insulation property between adjacent connecting terminals can be ensured by the insulating area, connection reliability can be improved. According to this method, it is possible to produce a plurality of connecting terminals in a fine pitch circuit at the same time.

Hereinafter, the method for producing the connecting terminal of the first embodiment of the present invention will be described in more detail with reference to the drawings, but the connecting method of the present invention is not limited to the drawings.

(a) Placement step

Firstly, as shown in Figure 4, a conductive connecting material having a curable resin composition 120 and a metal foil 110 is placed on a substrate 40 on which an electrode 41 is provided. At this time, when using a metal foil in a pattern, the conductive connecting material 50 and the electrode 41 on the substrate must be subjected to position adjustment. In Figure 4, the curable resin composition 120 is formed on one of the surfaces of the metal foil 110, but the curable resin composition 120 may be formed on the both surfaces of the metal foil 110. Further, in Figure 4, the conductive connecting material is placed so that the curable resin composition 120 is opposed to the connecting terminal, but it is also possible to place the conductive connecting material so that the metal foil 110 is opposed to the connecting terminal.
As shown in Figure 5, the conductive connecting material 50 may be bonded to the substrate 40 by thermal compression using a roll laminator, a pressing apparatus or the like. In Figure 5, the electrode 41 is covered with the curable resin composition 120, and the thickness of the thermosetting resin composition 120 may be smaller or larger than the thickness of the electrode 41, and can be suitably adjusted depending on purposes and applications. In addition, the surface of the electrode 41 may be subjected to treatments such as washing, polishing, plating and surface activation according to need in order to provide good electrical connection or to improve joining property with the metal foil.

(b) Heating step

In the heating step, the conductive connecting material 50 placed on the electrode 41 on the substrate 40 in the aforementioned placement step is heated at a temperature, which is equal to or more than the melting point of the metal foil, and at which curing of the curable resin composition is not completed. By performing this, as shown in Figure 6, a connecting terminal 150 can be formed on the electrode 41. Meanwhile, the area surrounding the connecting terminal 150 is filled with the curable resin composition to form an insulating area 140. As a result, the insulation property between the adjacent connecting terminals 150 can be ensured, and shorting circuit between the adjacent connecting terminals 150 can be prevented.
The melt viscosity, heating temperature and pressurization condition of the curable resin composition may be the same as those in the case where terminals are connected using the aforementioned conductive connecting material having the curable resin composition and the metal foil.

(c) Curing step

In the curing step, after the connecting terminal 150 and the insulating area 140 are formed in the aforementioned heating step, the curable resin composition is cured to fix the insulating area 140. By performing this, the joint between the electrode 41 on the substrate and the connecting terminal 150 can be reinforced. Particularly in the first embodiment of the present invention, because of using a curable resin composition having a high insulation resistance value at the time of a high melt viscosity, the insulation property of the insulating area can be ensured more sufficiently. Though there is no particular limitation, but the curing step is preferably carried out after the connecting terminal 150 is formed and the substrate 60 is mounted on another electrical or electronic component or substrate to be connected.
The heating temperature of the conductive connecting material in the curing step may be the same as that in the case where terminals are connected using the conductive connecting material having the curable resin composition and the metal foil.

(2) Second embodiment

Hereinafter, the method for producing the connecting terminal of the second embodiment of the present invention will be described.
The method for producing the connecting terminal of the second embodiment of the present invention comprises: a placement step in which the conductive connecting material including the thermoplastic resin composition and the metal foil is placed on an electrode of an electronic member; a heating step in which the conductive connecting material is heated at a temperature, which is equal to or higher than the melting point of the metal foil, and at which the thermoplastic resin composition is softened; and a solidifying step in which the thermoplastic resin composition is solidified (according to need).
In the production method of the second embodiment, it is possible to selectively aggregate heated/melted solder or tin on the electrode on the substrate to form the connecting terminal, and to form the insulating area consisting of the thermoplastic resin composition around the connecting terminal. As a result, the connecting terminal can be covered with the thermoplastic resin composition, and therefore, the conductive area is fixed. In addition, since the insulation property between adjacent connecting terminals can be ensured by the insulating area, connection reliability can be

improved. According to this method, it is possible to produce a plurality of connecting terminals in a fine pitch circuit at the same time.

Hereinafter, the method for producing the connecting terminal of the second embodiment of the present invention will be described in more detail.

(a) Placement step

In the case of using a conductive connecting material comprising a thermoplastic resin composition and a metal foil, it is possible to place the conductive connecting material on a substrate on which an electrode is provided as in the case of using the conductive connecting material comprising the thermosetting resin composition and the metal foil in the aforementioned first embodiment.

(b) Heating step

In the heating step, the conductive connecting material 50 placed on the electrode provided on the substrate in the aforementioned placement step is heated at a temperature, which is equal to or more than the melting point of the metal foil, and at which the thermoplastic resin composition is softened. By performing this, as in the case of the first embodiment, a connecting terminal can be formed on an electrode. Meanwhile, the area surrounding the connecting terminal is filled with the thermoplastic resin composition to form an insulating area. As a result, the insulation property between the adjacent connecting terminals can be ensured, and shorting circuit between the adjacent connecting terminals can be prevented.

The melt viscosity, heating temperature and pressurization condition of the thermoplastic resin composition may be the same as those in the case where terminals are connected using the aforementioned conductive connecting material having the thermoplastic resin composition and the metal foil.

(c) Solidifying step

In the solidifying step, after the connecting terminal and the insulating area are formed in the aforementioned heating step, the thermoplastic resin composition is cooled and solidified to fix the insulating area, thereby reinforcing the joint between the electrode and the connecting terminal.

Note that a cooling method and a preferred solidifying temperature for the thermoplastic resin composition are the same as those in the case where terminals are connected using the aforementioned conductive connecting material having the thermoplastic resin composition and the metal foil.

As described above, in the present invention, by using the conductive connecting material of the present invention, solder or tin can be selectively aggregated to a region at which the connecting terminal is formed, and therefore, the connecting terminal can be produced using a convenient method. According to the method for producing the connecting terminal of the present invention, it is possible to produce a plurality of connecting terminals at the same time, and in addition, an insulating area can be formed around them. Therefore, it is possible to fix the connecting terminals, and the insulation property between the adjacent connecting terminals can be ensured. Therefore, it is possible to produce connecting terminals having excellent connection reliability.

4. Electronic member with conductive connecting material and electrical/electronic component

The present invention also includes an electronic member with a conductive connecting material, wherein the conductive connecting material of the present invention is attached to an electrical connection surface of the electronic member. In the electronic member with the conductive connecting material of the present invention, the surface of the conductive connecting material to adhere to the electrical connection surface of the electronic member is preferably a resin composition layer. The resin composition layer may be directly attached to the electrical connection surface of the electronic member, or may be attached via an adhesive layer. By bonding the electronic members with the conductive connecting material of the present invention together or by bonding the electronic member with the conductive connecting material of the present invention to an electrical connection surface of another type of electronic member to be subjected to thermal compression bonding, such electronic members can be electrically connected to each other.

The present invention also includes semiconductor wafers, semiconductor chips, rigid substrates, flexible substrates and other electrical/electronic components, wherein electronic members are electrically connected using the conductive connecting material of the present invention obtained in the above-described way.

EXAMPLES

Hereinafter, the present invention will be specifically described by way of examples and comparative examples. Melt viscosities of resin compositions used in the examples and comparative examples, electrical resistance between opposed terminals of layered materials obtained, conductivity between opposed terminals, and presence or absence of solder particles remaining in areas other than the conductive pathway were measured or evaluated using the method described below.

(1) Melt viscosity

The melt viscosity of the obtained resin composition was measured using a viscoelasticity measurement apparatus ("ARES viscoelasticity measurement system" manufactured by Rheometric Scientific F. E. Ltd.) under the following conditions: 25 mmφ parallel plate; gap: 0.5mm when the resin composition is in the liquid form and 0.05 mm when the resin composition is in the film form; frequency: 10 rad/s; rate of temperature increase: 10°C/miniute when a tin-bismuth-based substance is used as a solder foil and 20°C/miniute when other solder foils are used. In this case, melt viscosities at heating temperatures used in the heating steps of the respective working examples and comparative examples were measured.

(2) Electrical resistance

The resistance between opposed terminals in the obtained layered material was measured by the 12-point measurement using the four-terminal method (resistance meter: "digital multi-meter VOA 7510" manufactured by Iwatsu Electric Co., Ltd.; measurement probe: "pin-type lead 9771" manufactured by HIOKI E. E. Corporation), and it was judged as follows: "A" when the average value is less than 30 mΩ; and "B" when the average value is 30 mΩ or more.

(3) Conductivity between opposed terminals

Regarding 10 pairs of opposed terminals in the obtained layered material, each cross-section between the terminals was observed using a scanning electron microscope ("JSM-7401F" manufactured by JEOL Ltd.), and it was judged as follows: "A" when a cylindrical conductive pathway is formed by solder in all the 10 pairs; "B" when no conductive pathway is formed in at least one pair of terminals; and "C" when shorting circuit occurs between adjacent terminals.

(4) Presence or absence of remaining solder

The cross section of the obtained layered material was observed by a scanning electron microscope (SEM) ("JSM-7401F" manufactured by JEOL Ltd.), and it was judged as follows: "A" when all the solder contributes to the formation of conductive pathways between opposed terminals; and "B" when the solder remains in resin in areas (insulating areas) other than those between opposed terminals (conductive areas) without contribution to the formation of conductive pathways.

(5) Melt viscosity of the resin composition at the melting point of the metal foil and melt viscosity of the resin composition in the heating step

About 10 mg of the obtained resin composition was weighed precisely, and the calorific value of curing was calculated using a differential scanning calorimeter (Seiko Instruments Inc.) with the rate of temperature increase of 5°C/minute, 10°C/minute and 20°C/minute.
Next, using the Kamal equation model (POLYMER ENGINEERING AND SCIENCE, JANUARY, 1973, Vol. 13, No. 1 Kinetics and Thermal Characterization of Thermoset Cure M. R. KAMAL and S. SOUROUR), the curing reaction rate (α) for time (t) to subject the resin composition to isothermal exposure was calculated.
Further, by applying the calculated curing reaction rate (α) and using the Cross model (AIChE Journal Vol. 28, No. 2 Studies of Mold Filling and Curing in the Reaction Injection Molding Process J. M. CASTRO and C. W. MACOSKO), the melt viscosity of the resin composition after 5 seconds at the melting point of the metal foil and the melt viscosity of the resin composition after 5 seconds in the heating step were calculated.
In the columns "Melt viscosity of resin composition at melting point of metal foil" and "Melt viscosity of resin composition in heating step" in Tables 1-6, melt viscosities are described in the upper portion and temperatures used for calculation of the melt viscosities are described in the lower portion.
Computation formulae of melt viscosities in the Kamal equation model and the Cross model are described below.
<Kamal equation model>

$$d\alpha / dt = \{k_1 \exp(E_1 / T) + k_2 \exp(E_2 / T) \alpha^m\}(1-\alpha)^n$$

$d\alpha / dt$ : Curing reaction velocity [1 / s],
$\alpha$ : Curing reaction rate [ - ],
$k_1$, $k_2$ : Curing velocity constant [1/ s],
T : Temperature [K],
$E_1$, $E_2$ : Activation temperature [ K ],
m, n : Reaction order [ - ].
<Cross model>

$$\eta(T, \gamma, \alpha) = \eta_m(T, \gamma) \{\alpha_g / (\alpha_g-\alpha)\}^{C_1+C_2\alpha}$$

$$\eta_m (T, \gamma) = \eta_0 (T) / [1 + \{\eta_0 (T) \gamma / \tau^*\}^{1-n}]$$

$$\eta_0 (T) = B \exp (T_b / T)$$

$\eta$: Viscosity rate [Pa·s ]
y: Shear velocity [1 / s ]
T: Temperature [ K ]
$\alpha$: Curing reaction rate [ - ]
$\alpha_g$: Curing reaction rate at gelation point

[Example 1]

39.3 parts by weight of epoxy resin ("EPICLON EXA830-LVP" manufactured by DIC Corporation, epoxy equivalent: 160 g/eq), 0.8 part by weight of carboxyl group-terminated butadiene-acrylonitrile copolymer ("CTBN1008-SP" manufactured by Ube Industries, Ltd.), 7.9 parts by weight of gentisic acid (Midori Kagaku Co., Ltd.), 2.0 parts by weight of sebacic acid (Tokyo Chemical Industry Co., Ltd.) and 0.2 part by weight of 2-phenyl-4-methylimidazole ("CUREZOL 2P4MZ" manufactured by Shikoku Chemicals Corporation) were mixed together to prepare a curable resin composition. Regarding the obtained curable resin composition, the melt viscosity (160°C) was measured according to the aforementioned method. The results are shown in Table 1.
The curable resin composition was applied to the both surfaces of the solder foil (Sn/Bi = 42/58, density = 8.7 g/cm$^3$, thickness: 10 $\mu$m) to prepare a conductive connecting material having a thickness of 50 $\mu$m.
Next, using the obtained conductive connecting material, terminals of substrates were connected to each other. The substrate consisted of an FR-4 base material (thickness: 0.1mm) and a circuit layer (copper circuit, thickness: 12 $\mu$m), and it had connecting terminals (terminal diameter: 100 $\mu$m, center distance between adjacent terminals: 300 $\mu$m) formed by applying Ni/Au plating (thickness: 3 $\mu$m) on the copper circuit. The aforementioned conductive connecting material was placed between such substrates having connecting terminals, and using a thermal compression bonding apparatus ("TMV1-200ASB" manufactured by Tsukuba Mechanics Co., Ltd.), thermal compression bonding (gap between substrates: 50 $\mu$m) was applied under the conditions of 160°C, 2MPa and 600 seconds to connect the terminals. After that, the curable resin composition was cured by heating at 180°C for 1. hour to obtain a layered material.
Regarding the obtained layered material, the electrical resistance and the conductivity between opposed terminals and presence or absence of solder particles remaining in the insulating areas were evaluated according to the aforementioned method. The results are shown in Table 1.

[Example 2]

39.3 parts by weight of epoxy resin ("EPICLON EXA830-LVP" manufactured by DIC Corporation, epoxy equivalent: 160 g/eq), 0.8 part by weight of carboxyl group-terminated butadiene-acrylonitrile copolymer ("CTBN1008-SP"

manufactured by Ube Industries, Ltd.), 6.0 parts by weight of gentisic acid (Midori Kagaku Co., Ltd.), 3.9 parts by weight of sebacic acid (Tokyo Chemical Industry Co., Ltd.) and 0.2 part by weight of 2-phenyl-4-methylimidazole ("CUREZOL 2P4MZ" manufactured by Shikoku Chemicals Corporation) were mixed together to prepare a curable resin composition. Regarding the obtained curable resin composition, the melt viscosity (160°C) was measured according to the aforementioned method. The results are shown in Table 1.
The curable resin composition was applied to the both surfaces of the solder foil (Sn/Bi = 42/58, density = 8.7 g/cm$^3$, thickness: 10 μm) to prepare a conductive connecting material having a thickness of 50 μm. Terminals of substrates were connected to each other in a manner similar to that in Example 1 except that this conductive connecting material was used, thereby obtaining a layered material.
Regarding the obtained layered material, the electrical resistance and the conductivity between opposed terminals and presence or absence of solder particles remaining in the insulating areas were evaluated according to the aforementioned method. The results are shown in Table 1.

[Example 3]

39.3 parts by weight of epoxy resin ("EPICLON EXA830-LVP" manufactured by DIC Corporation, epoxy equivalent: 160 g/eq), 0.8 part by weight of carboxyl group-terminated butadiene-acrylonitrile copolymer ("CTBN1008-SP" manufactured by Ube Industries, Ltd.), 7.9 parts by weight of gentisic acid (Midori Kagaku Co., Ltd.), 2.0 parts by weight of sebacic acid (Tokyo Chemical Industry Co., Ltd.) and 0.2 part by weight of 2-phenylimidazole ("CUREZOL 2PZ" manufactured by Shikoku Chemicals Corporation) were mixed together to prepare a curable resin composition. Regarding the obtained curable resin composition, the melt viscosity (160°C) was measured according to the aforementioned method. The results are shown in Table 1.
The curable resin composition was applied to the both surfaces of the solder foil (Sn/Bi - 42/58, density = 8.7 g/cm$^3$, thickness: 10 μm) to prepare a conductive connecting material having a thickness of 50 μm. Terminals of substrates were connected to each other in a manner similar to that in Example 1 except that this conductive connecting material was used, thereby obtaining a layered material.
Regarding the obtained layered material, the electrical resistance and the conductivity between opposed terminals and presence or absence of solder particles remaining in the insulating areas were evaluated according to the aforementioned method. The results are shown in Table 1.

[Comparative Example 1]

43.7 parts by weight of epoxy resin ("EPICLON EXA830-LVP" manufactured by DIC Corporation, epoxy equivalent; 160 g/eq), 0.9 part by weight of carboxyl group-terminated butadiene-acrylonitrile copolymer ("CTBN1008-SP" manufactured by Ube Industries, Ltd.), and 0.2 part by weight of 2-phenyl-4-methylimidazole ("CUREZOL 2P4MZ" manufactured by Shikoku Chemicals Corporation) were mixed together to prepare a curable resin composition. Regarding the obtained curable resin composition, the melt viscosity (160°C) was measured according to the aforementioned method. The results are shown in Table 1.
The curable resin composition was applied to the both surfaces of the solder foil (Sn/Bi = 42/58, density = 8.7 g/cm$^3$, thickness: 10 μm) to prepare a conductive connecting material having a thickness of 50 μm. Terminals of substrates were connected to each other in a manner similar to that in Example 1 except that this conductive connecting material was used, thereby obtaining a layered material.
Regarding the obtained layered material, the electrical resistance and the conductivity between opposed terminals and presence or absence of solder particles remaining in the insulating areas were evaluated according to the aforementioned method. The results are shown in Table 1.

[Comparative Example 2]

43.7 parts by weight of epoxy resin ("EPICLON EXA830-LVP" manufactured by DIC Corporation, epoxy equivalent: 160 g/eq), 0.9 part by weight of carboxyl group-terminated butadiene-acrylonitrile copolymer ("CTBN1008-SP" manufactured by Ube Industries, Ltd.), and 0.2 part by weight of 2-phenylimidazole ("CUREZOL 2PZ" manufactured by Shikoku Chemicals Corporation) were mixed together to prepare a curable resin composition. Regarding the obtained curable resin composition, the melt viscosity (160°C) was measured according to the aforementioned method. The results are shown in Table 1.
The curable resin composition was applied to the both surfaces of the solder foil (Sn/Bi = 42/58, density = 8.7 g/cm$^3$, thickness: 10 μm) to prepare a conductive connecting material having a thickness of 50 μm. Terminals of substrates were connected to each other in a manner similar to that in Example 1 except that this conductive connecting material was used, thereby obtaining a layered material.

Regarding the obtained layered material, the electrical resistance and the conductivity between opposed terminals and presence or absence of solder particles remaining in the insulating areas were evaluated according to the aforementioned method. The results are shown in Table 1.

Table I

| | | | Ex. 1 | Ex.2 | Ex.3 | Comp. Ex.1 | Comp. Ex. 2 |
|---|---|---|---|---|---|---|---|
| Formulation [part by weight] | Curable resin composition | Epoxy resin | 39.3 | 39.3 | 39.3 | 43.7 | 43.7 |
| | | Carboxyl group-terminaned butadiene-acrylonitrile copolymer | 0.8 | 0.8 | 0.8 | 0.9 | 0.9 |
| | | Gentisic acid | 7.9 | 6.0 | 7.9 | - | - |
| | | Sebacic acid | 2.0 | 3.9 | 2.0 | - | - |
| | | 2-phenyl-4-methylimidazole | 0.2 | 0.2 | - | 0.2 | - |
| | | 2-phenylimidazole | - | - | 0.2 | - | 0.2 |
| | Solder foil (Sn/Bi = 42/58, thickness: 10μm) | | 49.8 | 49.8 | 49.8 | 55.2 | 55.2 |
| | Total | | 100.0 | 100.0 | 100.0 | 100.0 | 100.0 |
| Physical properties of curable resin composition | | Melt viscosity (160°C) [Pa·s] | 0.03 | 0.02 | 0.03 | 0.05 | 0.05 |
| | | Melt viscosity of resin composition at melting point of metal foil [Pa·s] | 0.03  139°C | 0.02 139°C | 0.03 139°C | 0.06 139°C | 0.05 139°C |
| | | Melt viscosity of resin composition in heating step [Pa·s] | 0.03 160°C | 0.02 160°C | 0.04 160°C | 0.05 160°C | 0.04 160°C |
| Substrate connection conditions | Thermocompression bonding conditions | Temperature [°C] | 160 | 160 | 160 | 160 | 160 |
| | | Pressure [MPa] | 2 | 2 | 2 | 2 | 2 |
| | | Time [second] | 600 | 600 | 600 | 600 | 600 |
| Results of evaluation | Electrical resistance between opposed terminals | | A | A | A | B | B |
| | Conductivity between opposed terminals | | A | A | A | B | B |
| | Pretence or absence of remaining solder | | A | A | A | B | B |

[Example 4]

21.1 parts by weight of epoxy resin ("EPICLON-840S" manufactured by DIC Corporation, epoxy equivalent: 185 g/eq), 13.2 parts by weight of phenol resin ("PR-53647" manufactured by Sumitomo Bakelite Co., Ltd.), 15.8 parts by weight of phenoxy resin ("YX-6954" manufactured by Japan Epoxy Resins Co., Ltd.), 2.4 parts by weight of sebacic acid (Tokyo Chemical Industry Co., Ltd.), 0.3 part by weight of silane coupling agent ("KBM-303" manufactured by Shin-Etsu Chemical Co., Ltd.) and 0.01 part by weight of 2-phenyl-4-methylimidazole ("CUREZOL 2P4MZ" manufactured by Shikoku Chemicals Corporation) were mixed together to prepare a curable resin composition. Regarding the obtained curable resin composition, the melt viscosity (160°C) was measured according to the aforementioned method. The results are shown in Table 2.
The curable resin composition was applied to the both surfaces of the solder foil (Sn/Bi = 42/58, density = 8.7 g/cm$^3$, thickness: 10 μm) to prepare a conductive connecting material having a thickness of 50 μm. Terminals of substrates were connected to each other in a manner similar to that in Example 1 except that this film-like conductive connecting material was used, thereby obtaining a layered material. Regarding the obtained layered material, the electrical resistance and the conductivity between opposed terminals and presence or absence of solder particles remaining in the insulating areas were evaluated according to the aforementioned method. The results are shown in Table 2.

[Example 5]

21.1 parts by weight of epoxy resin ("EPICLON-840S" manufactured by DIC Corporation, epoxy equivalent: 185 g/eq), 10.5 parts by weight of phenol resin ("PR-53647" manufactured by Sumitomo Bakelite Co., Ltd.), 18.5 parts by weight of phenoxy resin ("YX-6954" manufactured by Japan Epoxy Resins Co., Ltd.), 2.4 parts by weight of sebacic acid (Tokyo Chemical Industry Co., Ltd.), 0.3 part by weight of silane coupling agent ("KBM-303" manufactured by Shin-Etsu Chemical Co., Ltd.) and 0.01 part by weight of 2-phenyl-4-methylimidazole ("CUREZOL 2P4MZ" manufactured by Shikoku Chemicals Corporation) were mixed together to prepare a curable resin composition as a resin composition. Regarding the obtained curable resin composition, the melt viscosity (160°C) was measured according to the aforementioned method. The results are shown in Table 2.
The curable resin composition was applied to the both surfaces of the solder foil (Sn/Bi = 42/58, density = 8.7 g/cm$^3$, thickness: 10 μm) to prepare a conductive connecting material having a thickness of 50 μm. Terminals of substrates were connected to each other in a manner similar to that in Example 1 except that this film-like conductive connecting material was used, thereby obtaining a layered material. Regarding the obtained layered material, the electrical resistance and the conductivity between opposed terminals and presence or absence of solder particles remaining in the insulating areas were evaluated according to the aforementioned method. The results are shown in Table 2.

[Comparative Example 3]

21.6 parts by weight of epoxy resin ("EPICLON-840S" manufactured by DIC Corporation, epoxy equivalent: 185 g/eq), 13.5 parts by weight of phenol resin ("PR-53647" manufactured by Sumitomo Bakelite Co., Ltd.), 16.2 parts by weight of phenoxy resin ("YX-6954" manufactured by Japan Epoxy Resins Co., Ltd.), 0.3 part by weight of silane coupling agent ("KBM-303" manufactured by Shin-Etsu Chemical Co., Ltd.) and 0.01 part by weight of 2-phenyl-4-methylimidazole ("CUREZOL 2P4MZ" manufactured by Shikoku Chemicals Corporation) were mixed together to prepare a curable resin composition as a resin composition. Regarding the obtained curable resin composition, the melt viscosity (160°C) was measured according to the aforementioned method. The results are shown in Table 2.
The curable resin composition was applied to the both surfaces of the solder foil (Sn/Bi = 42/58, density = 8.7 g/cm$^3$, thickness: 10 μm) to prepare a conductive connecting material having a thickness of 50 μm. Terminals of substrates were connected to each other in a manner similar to that in Example 1 except that this film-like conductive connecting material was used, thereby obtaining a layered material. Regarding the obtained layered material, the electrical resistance and the conductivity between opposed terminals and presence or absence of solder particles remaining in the insulating areas were evaluated according to the aforementioned method. The results are shown in Table 2.

[Comparative Example 4]

21.6 parts by weight of epoxy resin ("EPICLON-840S" manufactured by DIC Corporation, epoxy equivalent: 185 g/eq), 11.7 parts by weight of phenol resin ("PR-53647" manufactured by Sumitomo Bakelite Co., Ltd.), 17.0 parts by weight of phenoxy resin ("YX-6954" manufactured by Japan Epoxy Resins Co., Ltd.), 0.3 part by weight of silane coupling agent ("KBM-303" manufactured by Shin-Etsu Chemical Co., Ltd.) and 1.0 part by weight of 2-phenyl-4-methylimidazole ("CUREZOL 2P4MZ" manufactured by Shikoku Chemicals Corporation) were mixed together to prepare a curable resin composition as a resin composition. Regarding the obtained curable resin composition, the melt viscosity

(160°C) was measured according to the aforementioned method. The results are shown in Table 2.
The curable resin composition was applied to the both surfaces of the solder foil (Sn/Bi = 42/58, density = 8.7 g/cm$^3$, thickness: 10 μm) to prepare a conductive connecting material having a thickness of 50 μm. Terminals of substrates were connected to each other in a manner similar to that in Example 1 except that this film-like conductive connecting material was used, thereby obtaining a layered material. Regarding the obtained layered material, the electrical resistance and the conductivity between opposed terminals and presence or absence of solder particles remaining in the insulating areas were evaluated according to the aforementioned method. The results are shown in Table 2.

Table 2

| | | | Ex. 4 | Ex. 5 | Comp. Ex. 3 | Comp. Ex. 4 |
|---|---|---|---|---|---|---|
| Formulation [part by weight] | Curable resin composition | Epoxy resin | 21.1 | 21.1 | 21.6 | 21.6 |
| | | Phenol resin | 13.2 | 10.5 | 13.5 | 11.7 |
| | | Phenoxy resin | 15.8 | 18.5 | 16.2 | 17.0 |
| | | Sebacic acid | 2.4 | 2.4 | - | - |
| | | Silane coupling agent | 0.3 | 0.3 | 0.3 | 0.3 |
| | | 2-phenyl-4-methylimiazol | 0.01 | 0.01 | 0.01 | 1.0 |
| | Solder foil (Sn/Bi = 42/58 thickness: 10μm) | | 47.2 | 47.2 | 48.4 | 48.4 |
| | Total | | 100.0 | 100.0 | 100.0 | 100.0 |
| Physical properties of curable resin composition | | Melt viscosity (160°C) [Pa·s] | 9 | 8 | 10 | 12 |
| | | Melt viscosity of resin composition at melting point of metal foil [Pa·s] | 5.5 139 °C | 6.7 139 °C | 8.1 139 °C | 10.7 139 °C |
| | | Melt viscosity of resin composition in heating step [Pa·s] | 2.5 160 °C | 3.0 160 °C | 5.2 160 °C | 7.5 160 °C |
| Substrate connection conditions | Thermocompression bonding condtions | Temperature [°C] | 160 | 160 | 160 | 160 |
| | | Pressure [MPa] | 2 | 2 | 2 | 2 |
| | | Time [second] | 600 | 600 | 600 | 600 |
| Results of evaluation | Electrical resistance between opposed terminals | | A | A | B | B |
| | Conductivity between opposed terminals Conductivity between opposed terminals | | A | A | B | B |
| | Presence or absence of remaining solder | | A | A | B | B |

[Example 6]

40.0 parts by weight of epoxy resin ("EPICLON-840S" manufactured by DIC Corporation, epoxy equivalent: 185 g/eq), 25.0 parts by weight of phenol resin ("PR-53647" manufactured by Sumitomo Bakelite Co., Ltd.), 30.0 parts by weight of phenoxy resin ("YX-6954" manufactured by Japan Epoxy Resins Co., Ltd.), 4.5 parts by weight of sebacic acid (Tokyo Chemical Industry Co., Ltd.), 0.5 part by weight of silane coupling agent ("KBM-303" manufactured by Shin-Etsu Chemical Co., Ltd.) and 0.01 part by weight of 2-phenyl-4-methylimidazole ("CUREZOL 2P4MZ" manufactured by Shikoku Chemicals Corporation) were mixed together to prepare a curable resin composition. Regarding the obtained curable resin composition, the melt viscosity (200°C) was measured according to the aforementioned method. The results are shown in Table 3.

The obtained curable resin composition was applied to the both surfaces of the solder foil (Sn/Pb = 63/37 (weight ratio), density = 8.4 g/cm$^3$, thickness: 10 $\mu$m) to prepare a conductive connecting material having a thickness of 60 $\mu$m.

Next, using the obtained conductive connecting material, terminals of substrates were connected to each other. The substrate consisted of an FR-4 base material (thickness: 0.1 mm) and a circuit layer (copper circuit, thickness: 12 $\mu$m), and it had connecting terminals formed by applying Ni/Au plating (thickness: 3 $\mu$m) on the copper circuit (terminal diameter: 50 $\mu$m, center distance between adjacent terminals: 100 $\mu$m). For such terminal connection of substrates, the aforementioned conductive connecting material was cut to the same size as a connection area, it was placed on a connection region, and opposed terminals were subjected to position adjustment. Next, using a thermal compression bonding apparatus, the aforementioned conductive connecting material and the substrate were subjected to thermal compression bonding (pressure was controlled until right after starting pressure bonding and after that, the gap between substrates was controlled to become 50 $\mu$m) under the conditions of 200°C, 0.5 MPa and 120 seconds, thereby connecting the terminals. After that, the curable resin composition was cured by heating at 180°C for 1 hour to obtain a layered material. Regarding the obtained layered material, the electrical resistance and the conductivity between opposed terminals and presence or absence of solder particles remaining in the insulating areas were evaluated according to the aforementioned method. The results are shown in Table 3.

[Example 7]

A layered material was produced in a manner similar to that in Example 6, except that a curable resin composition was prepared by mixing 40.0 parts by weight of epoxy resin ("EPICLON-840S" manufactured by DIC Corporation, epoxy equivalent: 185 gleq), 20.0 parts by weight of phenol resin ("PR-53647" manufactured by Sumitomo Bakelite Co., Ltd.), 35.0 parts by weight of phenoxy resin ("YX-6954" manufactured by Japan Epoxy Resins Co., Ltd.), 4.5 parts by weight of sebacic acid (Tokyo Chemical Industry Co., Ltd.), 0.5 part by weight of silane coupling agent ("KBM-303" manufactured by Shin-Etsu Chemical Co., Ltd.) and 0.01 part by weight of 2-phenyl-4-methylimidazole ("CUREZOL 2P4MZ" manufactured by Shikoku Chemicals Corporation), and evaluation thereof was made. The results are shown in Table 3.

[Comparative Example 5]

A layered material was produced in a manner similar to that in Example 6, except that a curable resin composition was prepared by mixing 41.9 parts by weight of epoxy resin ("EPICLON-840S" manufactured by DIC Corporation, epoxy equivalent: 185 g/eq), 26.2 parts by weight of phenol resin ("PR-53647" manufactured by Sumitomo Bakelite Co., Ltd.), 31.4 parts by weight of phenoxy resin ("YX-6954" manufactured by Japan Epoxy Resins Co., Ltd.), 0.5 part by weight of silane coupling agent ("KBM-303" manufactured by Shin-Etsu Chemical Co., Ltd.) and 0.01 part by weight of 2-phenyl-4-methylimidazole ("CUREZOL 2P4MZ" manufactured by Shikoku Chemicals Corporation), and evaluation thereof was made. The results are shown in Table 3.

[Comparative Example 6]

A layered material was produced in a manner similar to that in Example 6, except that a curable resin composition was prepared by mixing 41.9 parts by weight of epoxy resin ("EPICLON-840S" manufactured by DIC Corporation, epoxy equivalent: 185 g/eq), 23.2 parts by weight of phenol resin ("PR-53647" manufactured by Sumitomo Bakelite Co., Ltd.), 33.4 parts by weight of phenoxy resin ("YX-6954" manufactured by Japan Epoxy Resins Co., Ltd.), 0.5 part by weight of silane coupling agent ("KBM-303" manufactured by Shin-Etsu Chemical Co., Ltd.) and 1.0 part by weight of 2-phenyl-4-methylimidazole ("CUREZOL 2P4MZ" manufactured by Shikoku Chemicals Corporation), and evaluation thereof was made. The results are shown in Table 3.

Table 3

| | | | Ex. 6 | Ex. 7 | Comp. Ex. 5 | Comp. Ex. 6 |
|---|---|---|---|---|---|---|
| Formulation [part by weight] | Resin composition | Epoxy resin | 40.0 | 40.0 | 41.9 | 41.9 |
| | | Phenol resin | 25.0 | 20.0 | 26.2 | 23.2 |
| | | Phenoxy resin | 30.0 | 35.0 | 31.4 | 33.4 |
| | | | 4.5 | 4.5 | - | - |
| | | Silane coupling agent | 0,5 | 0.5 | 0.5 | 0.5 |
| | | 2-phenyl-4-methylmidazole | 0.01 | 0.01 | 0.01 | 1.00 |
| | Total | | 100.0 | 100.0 | 100.0 | 100.0 |
| Physical properties of curable resin composition | | Melt viscosity of resin composition at melting point of metal foil [Pa·s] | 1.1<br>183°C | 1.4<br>183°C | 1.5<br>183°C | 2.2<br>183°C |
| | | Melt viscosity of resin composition in heating step [Pa·s] | 0.59<br>200°C | 0.62<br>200°C | 0.81<br>200°C | 0.86<br>200°C |
| Substrate connection conditions | Thermocompresssion bonding conditions bonding condtions | Temperature [°C] | 200 | 200 | 200 | 200 |
| | | Pressure [MPa] | 0.5 | 0.5 | 0.5 | 0.5 |
| | | Time [second] | 120 | 120 | 120 | 120 |
| Results of evaluation | Electrical resistance between opposed terminals (upper part: judgment lower part: resistance value mΩ | | A<br>22 | A<br>20 | B<br>109≤ | B<br>109≤ |
| | Conductivity between opposed terminals | | A | A | B | B |
| | Presence or absence of remaining solder | | A | A | B | B |

[Example 8]

Solder foil for preparing a conductive connecting material was changed from the above-described solder foil (Sn/Pb = 63/37 (weight ratio), density = 8.4 g/cm$^3$, thickness: 10 μm) to a different solder foil (Sn/Pb = 63/37 (weight ratio), density = 8.4 g/cm$^3$, thickness: 5 μm). Further, the terminal diameter of the connecting terminal on the substrate and the center distance between adjacent terminals were changed from 50 μm and 100 μm to 40 μm and 100 μm. In addition, control of the gap between substrates at the time of thermal compression bonding was changed from 50 μm to 35 μm. Except for the above-described matters, a layered material was produced in a manner similar to that in Example 6, and evaluation thereof was made. The results are shown in Table 4.

[Example 9]

Solder foil for preparing a conductive connecting material was changed from the above-described solder foil (Sn/Pb = 63/37 (weight ratio), density = 8.4 g/cm$^3$, thickness: 10 μm) to a different solder foil (Sn/Pb = 63/37 (weight ratio), density = 8.4 g/cm$^3$, thickness: 50 μm), and the thickness of the conductive connecting material was changed from 60 μm to 300 μm. Further, the terminal diameter of the connecting terminal on the substrate and the center distance between adjacent terminals were changed from 50 μm and 100 μm to 200 μm and 300 μm. In addition, control of the gap between substrates at the time of thermal compression bonding was changed from 50 μm to 200 μm. Except for

the above-described matters, a layered material was produced in a manner similar to that in Example 6, and evaluation thereof was made. The results are shown in Table 4.

[Example 10]

Solder foil for preparing a conductive connecting material was changed from the above-described solder foil (Sn/Pb = 63/37 (weight ratio), density = 8.4 g/cm$^3$, thickness: 10 μm) to a different solder foil (Sn/Pb = 63/37 (weight ratio), density = 8.4 g/cm$^3$, thickness: 100 um), and the thickness of the conductive connecting material was changed from 60 μm to 400 μm. Further, the terminal diameter of the connecting terminal on the substrate and the center distance between adjacent terminals were changed from 50 μm and 100 μm to 350 μm and 400 μm. In addition, control of the gap between substrates at the time of thermal compression bonding was changed from 50 μm to 350 μm. Except for the above-described matters, a layered material was produced in a manner similar to that in Example 6, and evaluation thereof was made. The results are shown in Table 4.

[Example 11]

Solder foil for preparing a conductive connecting material was changed from the above-described solder foil (Sn/Pb = 63/37 (weight ratio), density = 8.4 g/cm$^3$, thickness: 10 μm) to a different solder foil (Sn/Ag/Cu = 96.5/3.0/0.5 (weight ratio), density = 7.4 g/cm$^3$, thickness: 10 μm), and the temperature for measuring the melt viscosity of the curable resin composition was changed from 200°C to 230°C. Further, the heating temperature at the time of thermal compression bonding of the conductive connecting material and the substrate was changed from 160°C to 230°C. Except for the above-described matters, a layered material was produced in a manner similar to that in Example 4, and evaluation thereof was made. The results are shown in Table 4.

Table 4

<table>
<tr><th colspan="3"></th><th>Ex. 8</th><th>Ex. 9</th><th>Ex. 10</th><th>Ex. 11</th></tr>
<tr><td rowspan="7">Formulation [part by weight]</td><td rowspan="6">Resin composition</td><td>Epoxy resin</td><td>40.0</td><td>40.0</td><td>40.0</td><td>40.0</td></tr>
<tr><td>Phenol resin</td><td>25.0</td><td>25.0</td><td>25.0</td><td>25.0</td></tr>
<tr><td>Phenoxy resin</td><td>30.0</td><td>30.0</td><td>30.0</td><td>30.0</td></tr>
<tr><td>Sebacic acid</td><td>4.5</td><td>4.5</td><td>4.5</td><td>4.5</td></tr>
<tr><td>Silane coupling agent</td><td>0.5</td><td>0.5</td><td>0.5</td><td>0.5</td></tr>
<tr><td>2-phenyl-4-methylimidazole</td><td>0.01</td><td>0.01</td><td>0.01</td><td>0.01</td></tr>
<tr><td colspan="2">Total</td><td>100.0</td><td>100.0</td><td>100.0</td><td>100.0</td></tr>
<tr><td colspan="2" rowspan="2">Physical properties of curable resin composition</td><td>Melt viscosity of resin composition at melting point of metal foil [Pa·s]</td><td>1.1<br>183°C</td><td>1.1<br>183°C</td><td>1.1<br>183°C</td><td>0.34<br>217°C</td></tr>
<tr><td>Melt viscosity of resin composition in heating step [Pa·s]</td><td>0.59<br>200°C</td><td>0.59<br>200°C</td><td>0.59<br>200°C</td><td>0.25<br>230°C</td></tr>
<tr><td rowspan="3">Substrate connection conditions</td><td rowspan="3">Thermocompression bonding condtions</td><td>Temperature [°C]</td><td>200</td><td>200</td><td>200</td><td>230</td></tr>
<tr><td>Pressure [MPa]</td><td>0.5</td><td>0.5</td><td>0.5</td><td>00.5</td></tr>
<tr><td>Time [second]</td><td>120</td><td>120</td><td>120</td><td>120</td></tr>
</table>

(continued)

| | | | Ex. 8 | Ex. 9 | Ex. 10 | Ex. 11 |
|---|---|---|---|---|---|---|
| Results of evaluation | Electrical resistance between opposed terminals (upper part: judgment, lower part: resistance value mΩ) | | A<br>22 | A<br>20 | A<br>15 | A<br>22 |
| | Conductivity between opposed terminals | | A | A | A | A |
| | Presence or absence | of remaining solder | A | A | A | A |

[Example 12]

A layered material was produced in a manner similar to that in Example 11, except that a curable resin composition was prepared by mixing 40.0 parts by weight of epoxy resin ("EPICLON-840S" manufactured by DIC Corporation, epoxy equivalent: 185 g/eq), 19.5 parts by weight of phenol resin ("PR-53647" manufactured by Sumitomo Bakelite Co., Ltd.), 30.0 parts by weight of phenoxy resin ("YX-6954" manufactured by Japan Epoxy Resins Co., Ltd.), 10.0 parts by weight of phenolphthalein (Tokyo Chemical Industry Co., Ltd.), 0.5 part by weight of silane coupling agent ("KBM-303" manufactured by Shin-Etsu Chemical Co., Ltd.) and 0.01 part by weight of 2-phenyl-4-methylimidazole ("CUREZOL 2P4MZ" manufactured by Shikoku Chemicals Corporation), and evaluation thereof was made. The results are shown in Table 5.

[Example 13]

A layered material was produced in a manner similar to that in Example 6, except that a curable resin composition was prepared by mixing 40.0 parts by weight of epoxy resin ("EPICLON-840S" manufactured by DIC Corporation, epoxy equivalent: 185 g/eq), 25.0 parts by weight of phenol resin ("per-53647" manufactured by Sumitomo Bakelite Co., Ltd.), 30.0 parts by weight of phenoxy resin ("4256H40" manufactured by Japan Epoxy Resins Co., Ltd.), 4.5 parts by weight of sebacic acid (Tokyo Chemical Industry Co., Ltd.), 0.5 part by weight of silane coupling agent ("KBM-303" manufactured by Shin-Etsu Chemical Co., Ltd.) and 0.01 part by weight of 2-phenyl-4-methylimidazole ("CUREZOL 2P4MZ" manufactured by Shikoku Chemicals Corporation), and evaluation thereof was made. The results are shown in Table 5.

[Example 14]

The same curable resin composition as that of Example 6 was applied to one surface of a solder foil (Sn/Pb = 63/37 (weight ratio), density = 8.4 g/$cm^3$, thickness: 10 μm) to prepare a conductive connecting material having a thickness of 60 μm.
Next, using the obtained conductive connecting material, connecting terminals of a substrate were produced. The same substrate as that of Example 6 was used. The resin composition of the conductive connecting material was placed to contact the substrate, and using a thermal compression bonding apparatus, thermal compression bonding was performed to produce connecting terminals under the conditions of 200°C, 0.5 MPa and 120 seconds, thereby obtaining the substrate with connecting terminals. Regarding the obtained substrate with connecting terminals, conductivity between opposed terminals and presence or absence of solder particles remaining in the insulating areas were evaluated according to the aforementioned method. The results are shown in Table 5.

[Example 15]

Using the same conductive connecting material as that of Example 6, two 8-mm-square frame-like substrates having a 2-mm-square hole in the center portion were electrically connected to each other. At the peripheral portion of the above-described substrates, a copper circuit (terminal diameter: 50 μm, center distance between adjacent terminals: 100 μm) having a thickness of 12 μm whose surface layer has an Ni/Au plated layer having a thickness of 3 μm was formed. In order to connect the above-described substrates, the aforementioned conductive connecting material was cut to the same size as a connection area (8-mm-square frame shape having a 2-mm-square hole in the center portion), opposed terminals were subjected to position adjustment, and using a thermal compression bonding apparatus, thermal compression bonding (pressure was controlled until right after starting pressure bonding and after that, the gap between the substrates was controlled to become 50 μm) was performed under the conditions of 200°C, 0.5 MPa and 120 seconds,

thereby connecting the terminals. After that, the curable resin composition was cured by heating at 180°C for 1 hour to obtain a layered material. Regarding the obtained layered material, the electrical resistance and the conductivity between opposed terminals and presence or absence of solder particles remaining in the insulating areas were evaluated according to the aforementioned method. The results are shown in Table 5.

Table 5

| | | | Ex. 12 | Ex. 13 | Ex. 14 | Ex. 15 |
|---|---|---|---|---|---|---|
| Formulation [part by weight] | Curable resin composition | Epoxy resin | 40.0 | 40.0 | 40.0 | 40.0 |
| | | Phenol resin | 19.5 | 25.0 | 25.0 | 25.0 |
| | | Phenoxy resin | 30.0 | | 30.0 | 30.0 |
| | | Phenoxy resin 4256H40 | | 30.0 | | |
| | | Sebacic acid | | 4.5 | 4.5 | 4.5 |
| | | Phenolphthalin | 10.0 | | | |
| | | Silane coupling agent | 0.5 | 0.5 | 0.5 | 0.5 |
| | | 2-phenyl-4-methylimidazole | 0.01 | 0.01 | 0.01 | 0.01 |
| | Total | | 100.0 | 100.0 | 100.0 | 100.0 |
| Physical properties of curable resin composition | | Melt viscosity of resin composition at melting point of metal foil [Pa·s] | 0.57<br>217°C | 3.8<br>183°C | 1.1<br>183°C | 1.1<br>183°C |
| | | Melt viscosity of resin composition in heating step [Pa·s] | 0.32<br>230°C | 0.80<br>200°C | 0.59<br>200°C | 0.59<br>200°C |
| Substrate connection bonding conditions | Thermocompression conditions | Temperature [°C] | 230 | 200 | 200 | 200 |
| | | pressure [MPa] | 0.5 | 0.5 | 0.5 | 0.5 |
| | | Time [second] | 120 | 120 | 120 | 120 |
| Results of evaluation | Electrical resistance between opposed terminals (upper part: judgment, lower part: resistance value mΩ) | | A<br>24 | A<br>20 | - | A<br>23 |
| | Conductivity between opposed terminals | | A | A | A<br>connecting terminals | A |
| | Presence or absence of remaining solder | | A | A | A | A |

[Comparative Example 7]

Using the composition described in Table 6, a resin composition was prepared in a manner similar to that in Example 6.

Next, 2 % by volume of conductive fine particles (AU-205, average particle diameter: 5 μm, plastic core, Ni/Au plating, Sekisui Chemical Co., Ltd.) was blended in the prepared resin composition, and the mixture was homogeneously dispersed to prepare a conductive connecting material. A layered material was prepared in a manner similar to that in Example 6, except that the above-described prepared conductive connecting material was used, and evaluation thereof

was made. The results are shown in Table 6.

Table 6

| | | | Comp. Ex. 7 |
|---|---|---|---|
| Formulation [part by weight] | Curable resin composition | Epoxy resin | 40.0 |
| | | Phenol resin | 25.0 |
| | | Phenoxy resin | 30.0 |
| | | Sebacic acid | 4.5 |
| | | Silane coupling agent | 0.5 |
| | | 2-phenyl-4-methylimidazole | 0.01 |
| | Total | | 100.0 |
| Physical properties of curable resin composition | | Melt viscosity of resin composition at melting point of metal foil [Pa·s] | 1.1<br>183°C |
| | | Melt viscosity of resin composition in heating step [Pa·s] | 0.59<br>200°C |
| Substrate connection conditions | Thermocompression bonding condtions | Temperature [°C] | 200 |
| | | Pressure [MPa] | 0.5 |
| | | Time [second] | 120 |
| Results of evaluation | Electrical resistance between opposed terminals | | B |
| | Conductivity between opposed terminals | | A |
| | Presence or absence of remaining solder | | B electroconductive fine particles remained |

INDUSTRIAL APPLICABILITY

The conductive connecting material of the present invention is useful for electrical connection between electronic members and production of connecting terminals on a substrate. By using the conductive connecting material of the present invention, it is possible to provide highly-reliable electrical connection. In addition, it is possible to produce connecting terminals on fine pitch circuits with high accuracy.

[Explanations of letters or numerals]

10,20 substrate

11,21 terminal

110 metal foil

120 resin composition

130 conductive area

140 insulating area

## Claims

1. A conductive connecting material, which has a layered structure comprising: a resin composition containing a resin component and a compound having a flux function; and a metal foil selected from a solder foil and a tin foil.

2. The conductive connecting material according to claim 1, wherein in the layered structure, a metal foil layer is formed on at least a portion of a resin composition layer in a planar view.

3. The conductive connecting material according to claim 1, wherein in the layered structure, a metal foil layer is formed on at least a portion of a resin composition layer in a repeated pattern in a planar view.

4. The conductive connecting material according to claim 2 or 3, wherein in the layered structure, the metal foil layer is formed on at least a portion of the resin composition layer in a dotted line-like hole pattern, a stripe pattern, a polka-dot pattern, a rectangle pattern, a checker pattern, a frame pattern or a lattice pattern in a planar view.

5. The conductive connecting material according to any one of claims 1 to 4, comprising a layered structure consisting of a resin composition layer/a metal foil layer/a resin composition layer.

6. The conductive connecting material according to any one of claims 1 to 4, comprising a layered structure consisting of a resin composition layer/a metal foil layer.

7. The conductive connecting material according to any one of claims 1 to 5, wherein in the layered structure, the metal foil layer is formed approximately at the center in the thickness direction of the layered structure.

8. The conductive connecting material according to any one of claims 1 to 7, wherein the resin composition is in a liquid form at 25°C.

9. The conductive connecting material according to any one of claims 1 to 7, wherein the resin composition is in a film form at 25°C.

10. The conductive connecting material according to any one of claims 1 to 9, wherein the melt viscosity of the resin composition at the melting point of the metal foil is 0.01 to 10 Pa·s.

11. The conductive connecting material according to any one of claims 1 to 9, wherein the melt viscosity of the resin composition at the melting point of the metal foil is 10 to 100 Pa·s.

12. The conductive connecting material according to any one of claims 1 to 11, wherein the resin composition comprises a thermosetting resin.

13. The conductive connecting material according to claim 12, wherein the thermosetting resin comprises at least one selected from the group consisting of an epoxy resin, a (meth)acrylate resin, a phenoxy resin, a polyester resin, a polyimide resin, a silicone resin, a maleimide resin and a bismaleimide triazine resin.

14. The conductive connecting material according to claim 13, wherein the epoxy resin comprises a bisphenol A type epoxy resin or a bisphenol F type epoxy resin.

15. The conductive connecting material according to any one of claims 1 to 14, wherein the resin composition comprises a curing agent.

16. The conductive connecting material according to any one of claims 1 to 15, wherein the resin composition comprises a curing accelerator.

17. The conductive connecting material according to claim 16, wherein the curing accelerator is an imidazole compound.

18. The conductive connecting material according to any one of claims 1 to 17, wherein the compound having a flux function comprises a compound having a phenolic hydroxyl group and/or a carboxyl group.

19. The conductive connecting material according to any one of claims 1 to 18, wherein the compound having a flux

function comprises a compound represented by the following general formula (1):

$$HOOC-(CH_2)n-COOH\cdots\cdots \qquad (1)$$

wherein n is an integer from 1 to 20.

**20.** The conductive connecting material according to any one of claims 1 to 19, wherein the compound having a flux function comprises a compound represented by the following general formula (2) and/or (3):

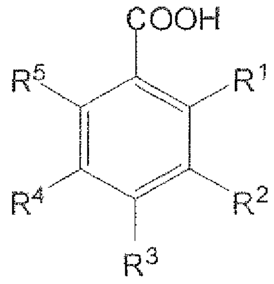

(2)

wherein $R^1$ to $R^5$ are each independently a monovalent organic group and at least one of $R^1$ to $R^5$ is a hydroxyl group;

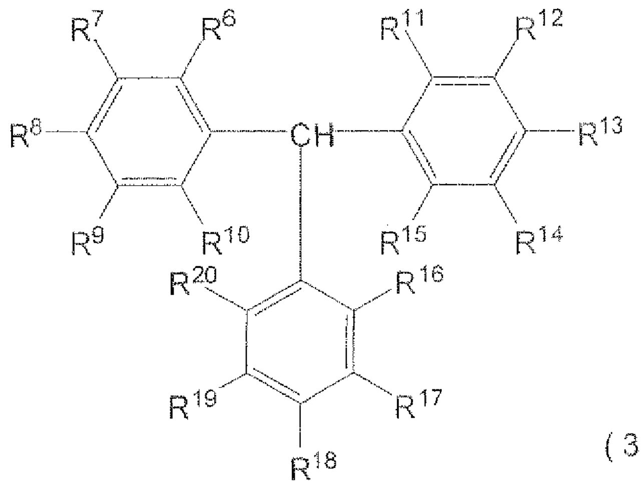

(3)

wherein $R^6$ to $R^{20}$ are each independently a monovalent organic group and at least one of $R^6$ to $R^{20}$ is a hydroxyl group or carboxyl group.

**21.** The conductive connecting material according to any one of claims 1 to 20, wherein the metal foil is formed by rolling, evaporation or plating.

**22.** The conductive connecting material according to any one of claims 1 to 21, wherein the melting point of the metal foil is 100 to 330°C.

**23.** The conductive connecting material according to any one of claims 1 to 22, wherein the metal foil is an alloy comprising at least two types of metals selected from the group consisting of Sn, Ag, Bi, In. Zn, Pb, Sb, Fe, Al, Ni, Au, Ge and Cu.

**24.** The conductive connecting material according to any one of claims 1 to 22, wherein the metal foil is made of Sn.

**25.** A method for connecting terminals comprising: a placement step in which the conductive connecting material according to any one of claims 1 to 24 is placed between opposed terminals; a heating step in which the conductive connecting material is heated at a temperature, which is equal to or higher than the melting point of the metal foil, and at which the resin composition is not completely cured; and a curing step in which the resin composition is cured.

**26.** A method for connecting terminals comprising: a placement step in which the conductive connecting material according to any one of claims 1 to 24 is placed between opposed terminals; a heating step in which the conductive connecting material is heated at a temperature, which is equal to or higher than the melting point of the metal foil, and at which the resin composition is softened; and a solidifying step in which the resin composition is solidified.

**27.** The method according to claim 25 or 26, wherein the melt viscosity of the resin composition in the heating step is 0.01 to 10 Pa·s.

**28.** The method according to claim 25 or 26, wherein the melt viscosity of the resin composition in the heating step is 10 to 100 Pa·s.

**29.** A method for producing connecting terminals comprising: a placement step in which the conductive connecting material according to any one of claims 1 to 24 is placed on an electrode of an electronic member; and a heating step in which the conductive connecting material is heated at a temperature, which is equal to or higher than the melting point of the metal foil, and at which the resin composition is not completely cured.

**30.** A method for producing connecting terminals comprising: a placement step in which the conductive connecting material according to any one of claims 1 to 24 is placed on an electrode of an electronic member; a heating step in which the conductive connecting material is heated at a temperature, which is equal to or higher than the melting point of the metal foil, and at which the resin composition is softened; and a solidifying step in which the resin composition is solidified.

**31.** The method for producing connecting terminals according to claim 29 or 30, wherein the melt viscosity of the resin composition in the heating step is 0.01 to 10 Pa·s.

**32.** The method for producing connecting terminals according to claim 29 or 30, wherein the melt viscosity of the resin composition in the heating step is 10 to 100 Pa·s.

**33.** An electronic member with a conductive connecting material, wherein the conductive connecting material according to any one of claims 1 to 24 is attached to an electrical connection surface of the electronic member.

**34.** An electrical or electronic component, wherein electronic members are electrically connected to each other by the conductive connecting material according to any one of claims 1 to 24.

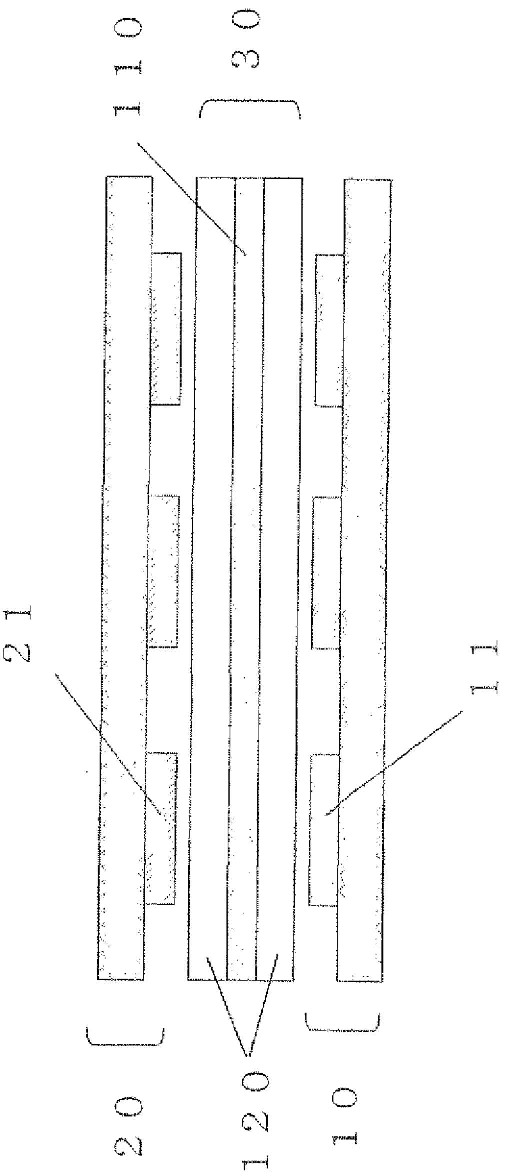


Fig. 1

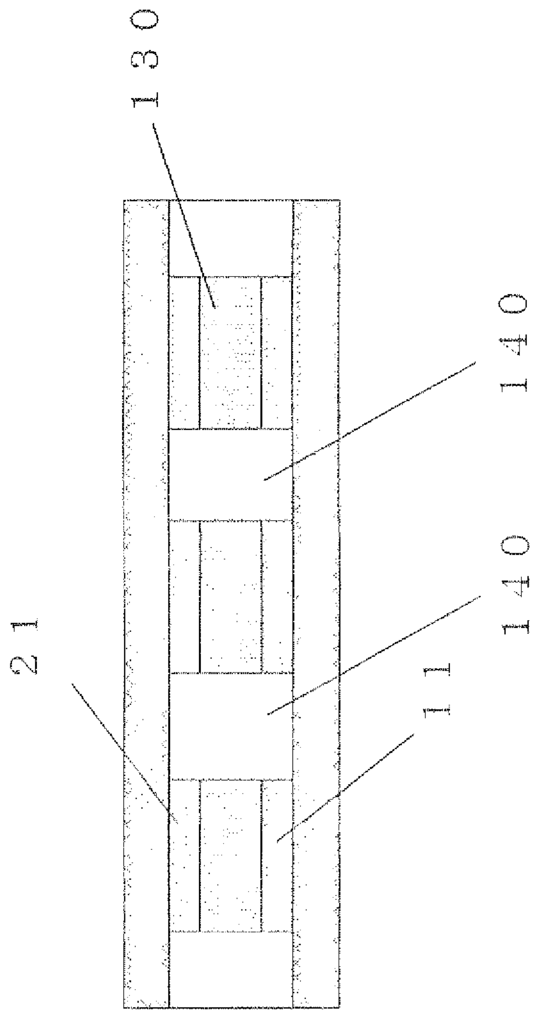


Fig. 2

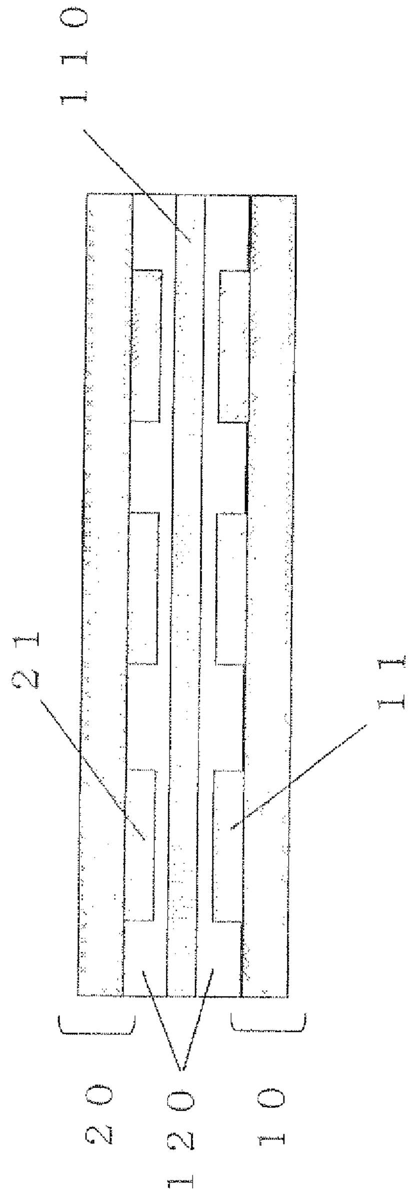


Fig. 3

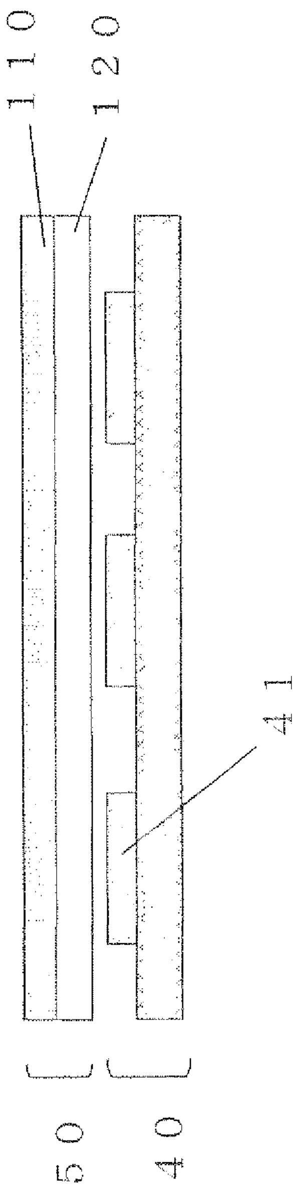


Fig. 4

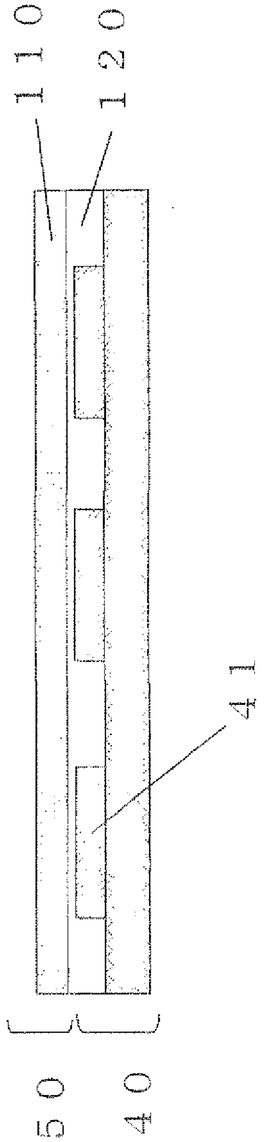


Fig. 5

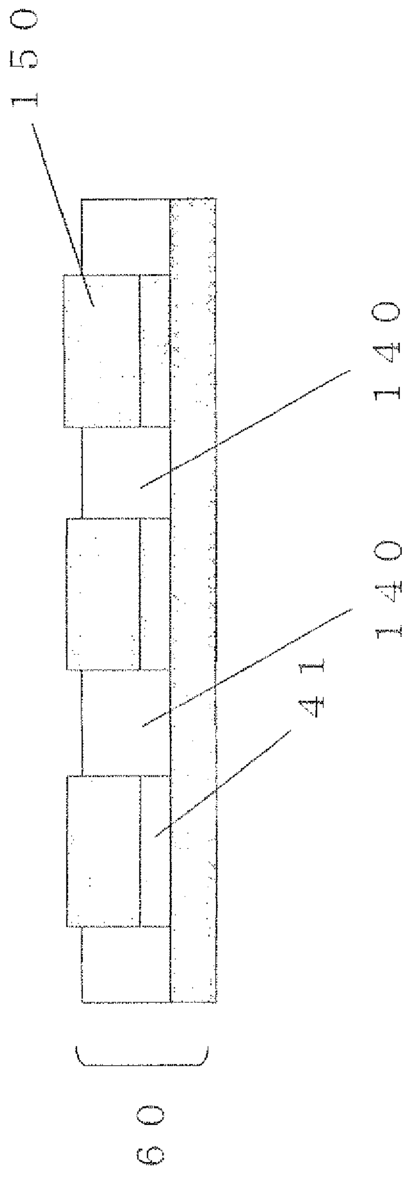


Fig. 6

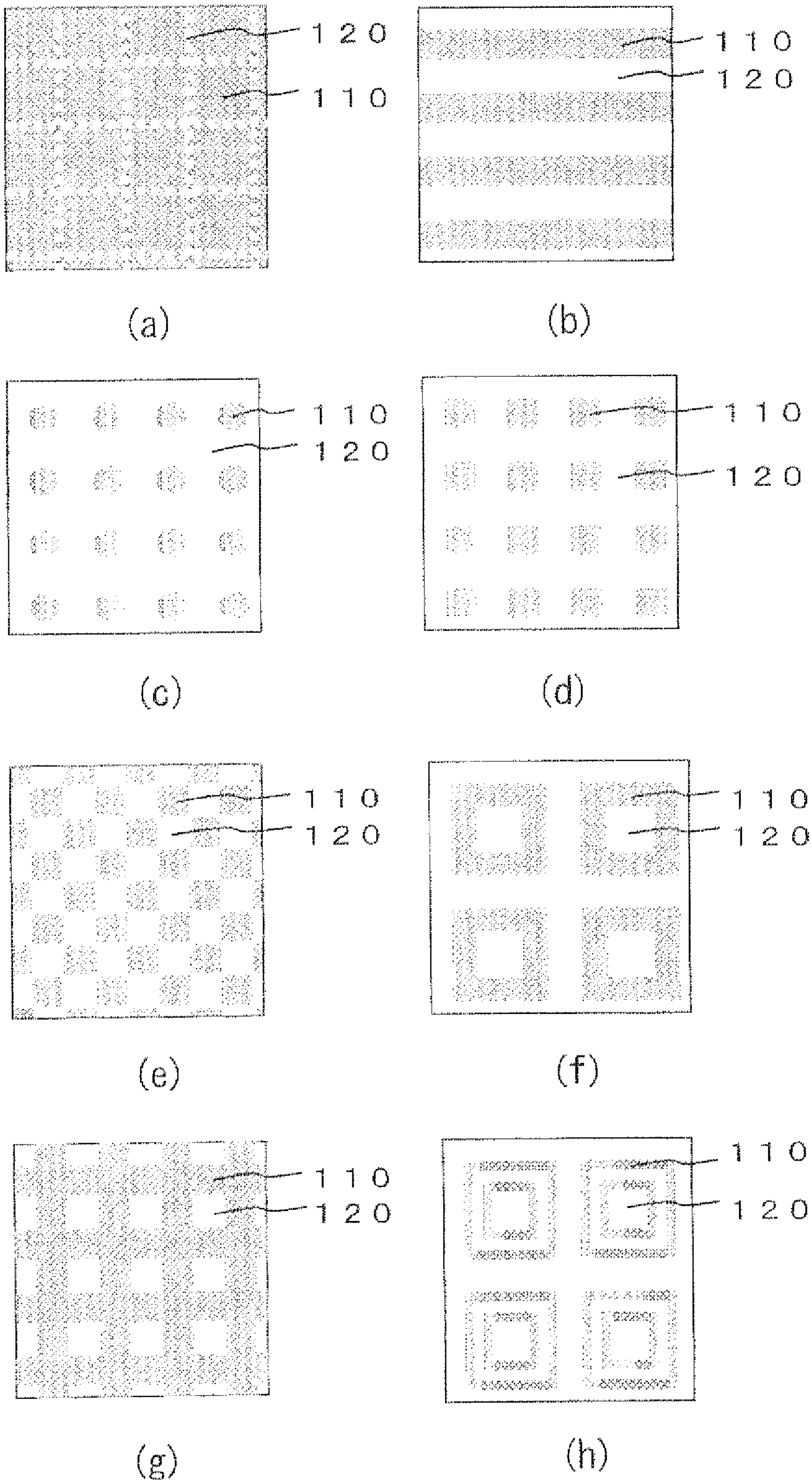
120
110
(a)
110
120
(b)
110
120
(c)
110
120
(d)
110
120
(e)
110
120
(f)
110
120
(g)
110
120
(h)

Fig. 7

**INTERNATIONAL SEARCH REPORT**

International application No.
PCT/JP2009/065414

A. CLASSIFICATION OF SUBJECT MATTER
H05K3/34(2006.01)i, C09J7/00(2006.01)i, C09J9/02(2006.01)i, C09J11/06 (2006.01)i, C09J163/02(2006.01)i, C09J201/00(2006.01)i, H01R11/01(2006.01)i

B. FIELDS SEARCHED

Minimum documentation searched (classification system followed by classification symbols)
H05K3/34, C09J7/00, C09J9/02, C09J11/06, C09J163/02, C09J201/00, H01R11/01

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br><br>Y | JP 2005-203693 A (Mitsubishi Electric Corp.), 28 July 2005 (28.07.2005), paragraphs [0018], [0024]; fig. 1 (Family: none) | 1,2,5-7, 22-24,33,34<br>3,4,8-21, 25-32 |
| Y | JP 2000-332393 A (Sumitomo Bakelite Co., Ltd.), 30 November 2000 (30.11.2000), paragraphs [0011] to [0022], [0030]; fig. 1 (Family: none) | 3,4,8-17,21, 25-32 |
| Y | WO 2005/081602 A1 (Matsushita Electric Industrial Co., Ltd.), 01 September 2005 (01.09.2005), paragraphs [0043] to [0047], [0052]; fig. 1, 3 & US 2007/0164079 A1 & CN 1922942 A | 3,4,8-12, 25-32 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 15 October, 2009 (15.10.09) | 27 October, 2009 (27.10.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2009/065414

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2008-111990 A (Sumitomo Bakelite Co., Ltd.), 15 May 2008 (15.05.2008), paragraphs [0048] to [0051] (Family: none) | 18-20 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP S61276873 B
- JP 2004260131 A


### Non-patent literature cited in the description


- **M. R. KAMAL ; S. SOUROUR.** Kinetics and Thermal Characterization of Thermoset Cure. *POLYMER ENGINEERING AND SCIENCE,* January 1973, vol. 13 (1
- **J. M. CASTRO ; C. W. MACOSKO.** Studies of Mold Filling and Curing in the Reaction Injection Molding Process. *AIChE Journal,* vol. 28 (2